(19)

Europäisches
Patentamt
European
Patent Office
Office européen
des brevets

(11) **EP 2 790 132 A2**

(12) **EUROPEAN PATENT APPLICATION**

(43) Date of publication:
**15.10.2014 Bulletin 2014/42**

(51) Int Cl.:
***G06K 19/077*** (2006.01)

(21) Application number: **14170400.7**

(22) Date of filing: **24.09.2010**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **24.09.2009 JP 2009218978**

(62) Document number(s) of the earlier application(s) in
accordance with Art. 76 EPC:
**10818863.2 / 2 482 236**

(71) Applicants:
• **Terrara Code Research Institute, Inc.
Tokai-shi, Aichi 477-0032 (JP)**

• **Japan Nus Co., Ltd
Shinjuku-ku, Tokyo 1600023 (JP)**

(72) Inventor: **Teraura, Nobuyuki
Aichi, 477-0032 (JP)**

(74) Representative: **Cougard, Jean-Marie et al
Cabinet Beau de Loménie
158, rue de l'Université
75340 Paris Cedex 07 (FR)**

Remarks:
This application was filed on 28-05-2014 as a
divisional application to the application mentioned
under INID code 62.

(54) **RFID tag**

(57)    Disclosed is an RFID tag that is provided with a laminate forming a layered structure; an antenna disposed with respect to the laminate so as to enable external communication; and an RFID circuit electrically connected to the antenna. The laminate has a shielding member for shielding from radiation, and the RFID circuit is arranged in the laminate so as to be covered by the shielding member.

FIG.1A

## Description

## TECHNICAL FIELD

Embodiments of the present invention relate to an RFID (radio frequency identification) tag exchanging information in a noncontact manner.

## BACKGROUND ART

The above-mentioned RFID tag is provided with an antenna and an RFID circuit, such as an IC (integrated circuit) chip, electrically connected to the antenna, so that information is writable into and readable from the RFID circuit via the antenna by the tag reader/writer in the non-contact manner. In this case, the RFID tag configures the RFID system as a slave to the tag reader/writer as a master. The RFID tag has recently been introduced into various fields for the purposes of commodity management, traceability of article history and the like.

For example, the RFID tag is attached to clothes to be cleaned at laundries, serving for process management in a cleaning plant or the like. For this purpose, an IC tag inlet has been proposed which comprises an insulated substrate mounted with an IC chip and an antenna coil and is disposed in a housing for a tray which is formed independent of the inlet and is configured to be integral with the tray by embedding resin.

Furthermore, another RFID tag has been proposed which comprises an antenna and an IC chip both sandwiched between upper glass and lower glass particularly for the purpose of improving chemical resistance. According to this configuration, since the antenna and the IC chip are covered by resin or glass, the RFID tag can be applied even to an environment where an organic solvent or the like is used.

Patent Document 1: JP-A-2006-98866
Patent Document 2: JP-A-2006-72804
Patent Document 3: JP-A-1998-250426

## DISCLOSURE OF THE INVENTION

On the other hand, it has recently been requested to prevent accidents by execution of various management using an RFID tag in an environment that results in radiation exposure, such as nuclear power plants. However, the RFID tag cannot be used in such a specific environment that the RFID tag with a good environmental applicability as described above causes data error due to radioactive ray. More specifically, the RFID tag needs to ensure communication with the outside with the use of an antenna. On the other hand, the RFID tag needs to be protected to avoid damage due to radiation. It would be difficult for the RFID tag to normally function in the aforementioned specific environment without the protection to avoid damage due to radiation. No prior art documents are suggestive of resistance to radiation.

The prior art has provided one type of an RFID tag which detects data error using a CRC check code and corrects a single-bit error to restore the data. However, when the RFID tag is exposed to radiation, data error is accumulated in the memory with lapse of radiation exposure time. Furthermore, there is a possibility of continuous burst error covering a plurality of bits in the memory depending upon an amount of radiation. Thus, it transpires that data error cannot be detected as well as the single-bit error. The RFID tag is not assumed to be used in such a specific environment as to be exposed to radiation or cosmic radiation, and it is difficult to use the RFID tag in the aforementioned specific environment with a coping process such as the above-mentioned error correction.

Therefore, it is an object of the invention to provide an RFID tag which can prevent occurrence of data error in a specific environment in which the RFID tag is exposed to radiation and can normally function.

There is provided an RFID tag which includes a laminate having a laminated structure; an antenna provided on the laminate so as to be capable of communicating with outside; and an RFID circuit electrically connected to the antenna, wherein the laminate has a shielding member which shields radiation; and the RFID circuit is disposed in the laminate so as to be covered by the shielding member.

For illustrative purpose, there is also described hereafter a data management system for managing data, in which communication is carried out between a master and a slave by a wireless communication unit in a non-contact manner, wherein the slave includes a nonvolatile storage unit which stores data and redundant data for correcting error in the data and a slave side control section controlling the entire slave; the master includes a master side control section controlling data read/write via the wireless communication unit; an error detection processing is carried out based on the redundant data regarding data read from the nonvolatile storage unit by the slave side control section or the master side control section, and an error correction processing is carried out when an error has been detected in the error detection processing; the redundant data includes data encoded as a bit pair of 01 indicative of one of two values of 0 and 1 each bit of data indicates and 10 indicative of the other value; and the slave or master side control determines in the error detection processing that the bit pair includes an error, when both bits of the bit pair are 0.

## BRIEF DESCRIPTION OF THE DRAWINGS

FIGS. 1A and 1B are schematic longitudinal side sectional view and transverse sectional side view of an RFID tag according to a first embodiment, respectively;
FIG. 2 is an enlarged longitudinal side section of part of a shielding member near the wiring material;

FIG. 3 is a schematic block diagram showing an electrical arrangement of the RFID tag and data management system;

FIG. 4 is a view showing an example of RFID tag applied to a maintenance engineering system of nuclear facilities;

FIG. 5 is a graph showing the relationship between the thickness of neutron ray shielding member and neutron ray transmittance;

FIG. 6 is a graph showing the relationship between the thickness of gamma ray shielding member and gamma ray transmittance;

FIG. 7 is a graph showing the relationship between the neutron energy and absorption cross-section of materials;

FIGS. 8A and 8B are a view similar to FIG. 1A and a schematic view in the case where the RFID tag is attached to piping to which a heat insulator is applied, showing a second embodiment, respectively;

FIG. 9 is a view similar to FIG. 1A, showing a third embodiment;

FIG. 10 is a view similar to FIG. 1A, showing a fourth embodiment;

FIGS. 11A and 11B are views similar to FIGS. 1A and 1B, showing a fifth embodiment, respectively;

FIGS. 12A and 12B are views similar to FIGS. 1A and 1B, showing a sixth embodiment, respectively;

FIG. 13 shows types of RFID tags and tag reader/writers and explanation of combinations, showing a seventh embodiment;

FIG. 14 is a block diagram showing electrical arrangements of the passive RFID tag and the tag reader/writer and a schematic configuration of data management system;

FIGS. 15A and 15B show map images of memories of an active RFID tag and tag reader/writer respectively;

FIG. 16 shows a map image of a memory of the passive RFID tag;

FIGS. 17A and 17B are views explaining main data, first error detection code and second error detection code;

FIG. 18 shows a memory map of a memory of the RFID tag;

FIG. 19 is a view explaining bit pairs of main data and first error detection code and examples of actually used addresses in the bit pairs, respectively;

FIG. 20 is a view explaining an error detecting process and an error correcting process both using a parity code;

FIGS. 21A and 21B show data encoded as bit pair and examples of main data and first error detection code both encoded as bit pair;

FIG. 22 shows an error in which data changes from 1 to 0 in one direction and an example of substitute pattern of substitute data;

FIG. 23 is a flowchart showing an entire processing in the case where data is written;

FIG. 24 is a flowchart showing an entire processing in the case where data is read;

FIG. 25 is a flowchart showing an example of process to read data continuously with respect to the same address;

FIG. 26 is a flowchart showing a related data reading process;

FIG. 27 is a flowchart showing an error correcting process using redundant data;

FIG. 28 is a flowchart showing an error correcting process regarding a first error detection signal;

FIG. 29 is a flowchart showing an error correcting process regarding multiplexing;

FIG. 30 is a flowchart showing an error correcting process regarding parity code;

FIG. 31 is a flowchart showing an error correcting process regarding first and second error detection codes;

FIG. 32 is a view explaining an error correcting process based on redundant data;

FIG. 33 is a view explaining an error correcting process based on triplicated data, showing an eighth embodiment;

FIG. 34 is a view similar to FIG. 21B, showing a ninth embodiment;

FIG. 35 is a view similar to FIG. 34, showing a tenth embodiment;

FIG. 36 is a flowchart showing an error correcting process regarding ID data, showing an eleventh embodiment;

FIG. 37 explains objects to which error corrections are applied regarding various error correcting programs, respectively, showing a twelfth embodiment;

FIG. 38 is a flowchart showing processing contents by main or auxiliary error correction programs;

FIG. 39 is a flowchart showing processing contents of simplified error correction program;

FIG. 40 is a view similar to FIG. 17A, showing a thirteenth embodiment; and

FIG. 41 is a view similar to FIG. 40.

**Explanation of Reference Symbols**

In the drawings, reference symbols 1 and 1a to 1a designate RFID tags, 2 a laminate, 3 and 3' antennas (wireless communication unit), 4 and 4' RFID circuits (control circuits), 5 first laminated part, 6 a second laminated part, 7 and 7' gamma ray shielding member, 12 a sensor (detecting unit), 13 a power supply, 15 and 72A nonvolatile storage unit, 16 and 71A tag side control (slave side control), 17 communication section (wireless communication unit), 20, 20A and 20B tag reader/writers (electronic devices, storage devices), 20a antenna (wireless communication unit), 21 data management system, 30, 33, 35, 38, 40 and 45 RFID tags respectively, 31 and 36 holes respectively, 32 and 34 heat transfer parts (detection units) respectively, 41 IC chip (RFID circuit), 42 base material, 46 coupling unit, 70 and 70A to 70C RFID tags (storage devices) respectively, 71C tag side control, 72C nonvolatile storage unit, 75 antenna (wireless communication unit), 76 RFID circuit, 77 communication part (wireless communication unit), 82 equipment side control (master side control), 83 equipment side storage unit (master side storage unit), 84 communication part (wireless communication unit), and 86 reader/writer circuit (control circuit).

## BEST MODE FOR CARRYING OUT THE INVENTION

<First Embodiment>

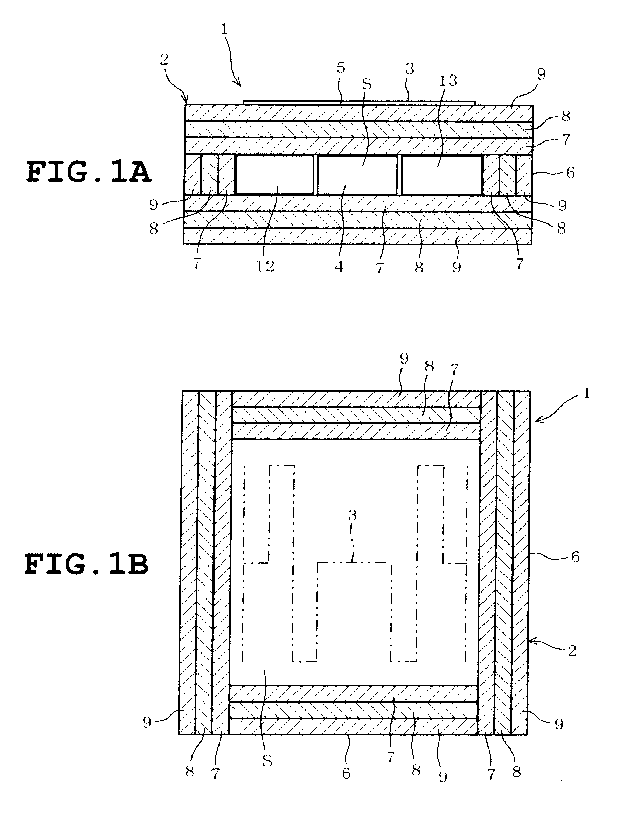

A first embodiment will be described with reference to FIGS. 1 to 7. An RFID tag 1 comprises a laminate 2 having a lamination structure, an antenna 3 which is provided on the laminate so as to be capable of communicating with outside, and an electric component (electronic component) including an RFID circuit 4 electrically connected to the antenna 3. The laminate 2 has a first laminate part 5 which sandwiches the RFID circuit 4 from above and from below and is vertically laminated and a second lamination 6 which surrounds sides of the RFID circuit 4 and is laminated in a direction perpendicular to the first lamination direction, whereby the laminate 2 is formed into a rectangular plate shape.

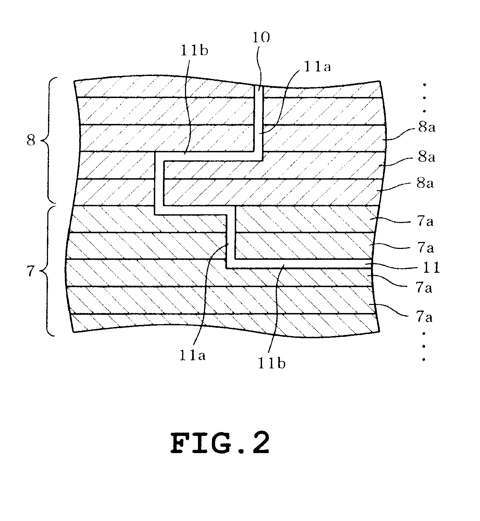

Each of the first and second laminate parts 5 and 6 has a gamma beam shielding member 7 serving as an inner layer, a neutron ray shielding member 8 serving as a middle layer and an exterior resin 9 serving as an outer layer. The shielding members 7 and 8 include respective wiring units for wiring a wire material 11 which will be described later. The gamma beam shielding member 7 comprises a plurality of layers 7a (see FIG. 2) each of which comprises lead serving as a main composition and contains lead powder in silicon rubber. The neutron ray shielding member 8 comprises a plurality of layers 8a (see FIG. 2) each of which comprises boron compound serving as a main composition and contains boron powder in silicon rubber. The first laminate part 5 is formed into a multilayer structure including 26 layers 7a and 8a of the shielding members 7 and 8 in total, for example. The shielding members 7 and 8 and the exterior resin 9 are vertically stuck so as to be symmetrical with the RFID circuit 4 being sandwiched. The second lamination 6 is also formed into a multilayer structure including 26 layers of shielding members 7 and 8 and exterior resin 9 laminated in the front-back direction and the right-left direction along peripheral sides of the first laminate part 5 with the RFID circuit 4 being surrounded. A hollow shielding space S is defined by the first and second laminate parts 5 and 6 in the laminate 2 so that the entire RFID circuit 4 is covered by the shielding members 7 and 8.

A wiring space (a wiring unit) 10 is continuously formed in the shielding members by the first and second shielding members 7 and 8. The wiring space 10 is provided for electrically connecting the antenna 3 and the RFID circuit 4 together, as shown in FIG. 2. The wiring space 10 is formed into a meandering shape and communicates between the outside of the shielding members 7 and 8 and the shielding space S, so that a radiation shielding function by the shielding members 7 and 8 is not damaged. A wiring material 11 is provided in the wiring space 10, thereby forming via holes 11a and implant portions 11b. Thus, the laminate 2 in the embodiment is understood as a multilayer board provided with the via holes 11a or implant portions 11b serving as conductive layers interlayer-connected in the shielding members 7 and 8. Furthermore, when a printed board (a wiring unit) formed by print-wiring the conductive layers as copper foil on the surfaces of the layers 7a and 8a is used as the shielding members 7 and 8, an inexpensive configuration can be achieved.

The antenna 3 is disposed on the exterior resin 9 outside the shielding members 7 and 8 in FIG. 1A. The antenna 3 comprises a pair of right and left meandering antenna patterns (see two dot chain line in FIG. 1B), for example, although detailed description will be eliminated. A terminal is connected via a wiring material to the RFID circuit 4 in each antenna pattern. The antenna 3 receives electric waves transmitted from a tag reader/writer 20 or transmits electric waves to the tag reader/writer 20.

The RFID tag 1 in the embodiment is of an active type that can realize intercommunication in a wide range. A printed board (not shown) is provided in the shielding space S and various electric components such as a sensor portion 12, a power supply (an electric cell) 13 and the like are mounted on the printed board other than the RFID circuit 4.

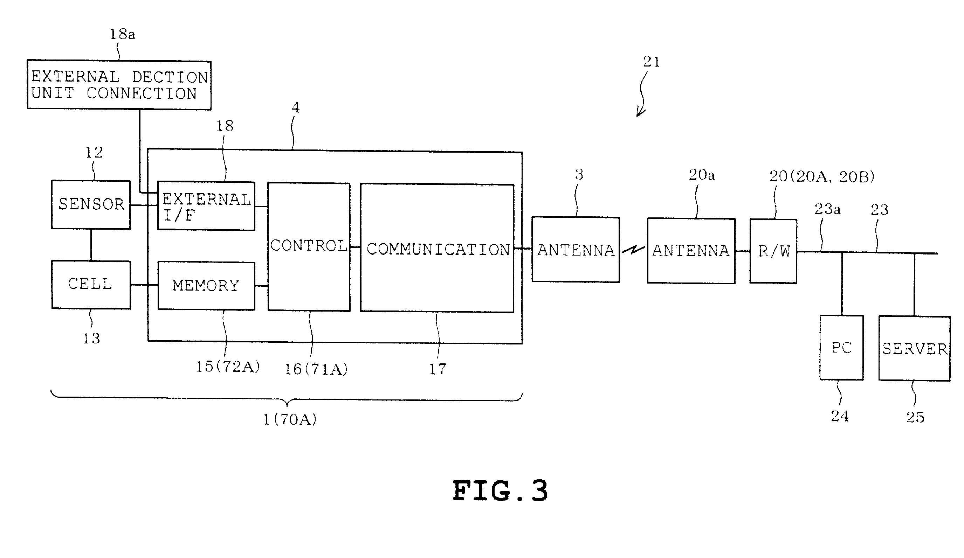

FIG. 3 shows a schematic system configuration of a data management system 21 together with an electrical configuration of the RFID tag 1. Firstly, the RFID circuit 4 includes as a main component a control 16 composed of MPU (a micro processing unit) and a memory 15 connected to the control 16, a communication part 17 an external interface (I/F) 18.

A sensor (a detection unit) 12 for detecting an external environment is connected to the external I/F 18. Various detection units can be used as the sensor 12 according to intended use of the RFID tag 1 and include vibration sensors, temperature sensors, radiation sensors and sound sensors. Furthermore, an external detection unit connecting portion 18a is connected to the I/F 18, and the laminate 2 is formed with a wiring space (not shown) for the external detection unit separately from the aforementioned wiring space 10. More specifically, an external detection unit (a current sensor, voltage sensor, pressure sensor, flow rate sensor or the like, for example) which will be described later is provided outside the RFID tag 1 and is configured to be connectable to the RFID circuit 4 via a wiring material of a wiring space for the external detection unit and an external detection unit connecting portion 18a.

A memory (a storage unit) 15 is composed of only an FRAM (ferroelectric random access memory®) as a nonvolatile memory rewritably storing data obtained from the communication part 17, the sensor part 12 and the external detection unit and the like. The FRAM is superior in radiation resistance and has functions of both a ROM serving as a read only memory and a RAM temporarily storing data. A MRAM (magnetic random access memory) may be used as the memory 15 or may be constituted by a ROM, RAM and EEPROM (electrically erasable programmable ROM), instead of the FRAM. The control 16 is configured to write and store external information detected by the sensor 12, various data necessary for management (an equipment management number, installation date, inspection/replacement history) and the like in the FRAM.

When a data signal contained in electric waves received by the antenna 3 is transmitted via the wiring material to the communication 17, the communication 17 executes a process to demodulate the data signal to original data. The communication 17 constitutes a wireless communication unit together with the antenna 3. The control 16 carries out rewrite and write of stored contents of the memory 15 according to contents of the data (a command from the tag reader/writer 20), and the like. The control 16 further controls the communication 17 to transmit data stored in the memory 15, based on instruction data from the tag reader/writer 20. A carrier wave of a predetermined frequency band is modulated in the communication 17 on the basis of data taken out of the memory 15 and then transmitted from the antenna 3 via the wiring material 11 to the tag reader/writer 20.

The data management system 21 comprises the tag reader/writer 20 performing data communication with the RFID tag 1 via the antenna 20a in a non-contact manner, a personal computer (information processing/operating device) 24 connected via a communication line 23a (wireless communication is also available) to the tag reader/writer 20, and a server 25 connected via a communication line (a communication network) to the personal computer 24. The personal computer 24 outputs instruction data by manipulated input or the like via the communication line 23a to the tag reader/writer 20, and the tag reader/writer 20 outputs data relating to the aforesaid tag reader/writer 20 to the personal computer 24.

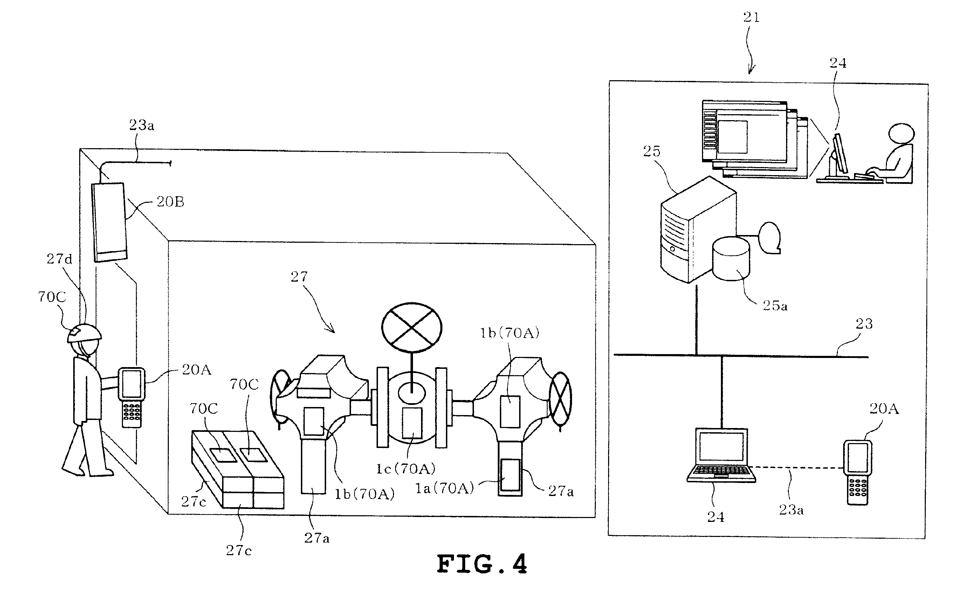

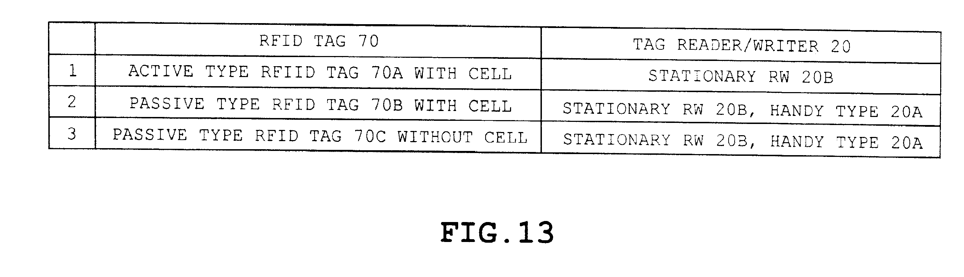

FIG. 4 illustrates as an example the data management system 21 which is applied to the maintenance of a facility 27 exposed to radiation, such as a nuclear power facility, for example, a thermal neutron reactor. The facility 27 is provided with an RFID tag 1a provided on piping 27a forming a flow path and having a temperature sensor, an RFID tag 1b provided on piping 27a and having a flow rate sensor for detecting a flow rate of the flow path, an RFID tag 1c incorporating a sound sensor for detecting abnormal sound in the facility 27, and the like. Thus, RFID tags corresponding to various management points are provided. A handy type tag reader/writer 20A or a stationary tag reader/writer 20B (see FIGS. 4 and 13) is used as the tag reader/writer 20. The tag reader/writer 20 carries out wireless communication with the personal computer 24 or communication via the communication line 23a. The personal computer 24 is located in a control room separated from the facility 27, for example and configured to exchange various data such as instruction via the communication line 23 to the server 25, response from the server 24 via the communication line 23 and the like. Data base 25a of the server 25 stores various data about the facility 27, for example, a management number, installation date, inspection/replacement history for every component and equipment of the facility 27, data detected by the aforesaid sensors (sensor information) and the like. In response to call by the server 25, data is acquired and referred to or data is written, if necessary.

In the above-described data management system 21, sensor information or the like can be obtained from the RFID tags 1a to 1c at a location away from the facility 27 using the handy type or stationary tag reader/writer 20A or 20B. Furthermore, various information about the RFID tag 1c can synthetically be managed by the data base 25e and information obtained by the personal computer 24 can be analyzed and comprehended. In a case where a temperature rise tendency is identified on the basis of temperature data obtained from the temperature sensor of the RFID tag 1, system administrator's attention is invited through a screen or sound on the personal computer 24 even when the temperature data is within a normal value. Furthermore, in the same manner, even when sensor information about vibration, radiation, sound or the like is within a range of normal data, caution can be caused by informing with the use of an informing unit such as a microcomputer 24 or the like before a bad condition becomes obvious in a case where the information shows a tendency differing from data at a normal condition. Accordingly, vibration, temperature, abnormal sound and radiation level of the facility 27 or equipment can be intensively monitored, and maintenance can be carried out before an abnormal condition becomes obvious, and traceability can be established and maintenance can be rendered more efficient.

The inventor has shown a mechanism of causing data error in an ordinary RFID tag exposed to radiation (differing from the aforesaid RFID tag 1). More specifically, three cases are assumed as causes for data error, that is, case (1) where radiation enters a memory storing data in an RFID circuit such as IC chip, thereby causing data error, case (2) where radiation enters a circuit other than the memory (a circuit for controlling the memory) and data error is caused by write of error data due to malfunction of the circuit into the memory, and case (3) where radiation incidence on the circuit results in abnormal voltage, which breaks part of the circuit with the result that data cannot be read.

The laminate 2 of the embodiment is configured in the following in order that RFID tag 1 may be used under the environment of radiation. More specifically, the laminate 2 is configured so that the entire circuit including the memory 15, control 16, communication 17, external I/F 18 and the like is covered by shielding members 7 and 8. The neutron shielding member 8 comprises silicon rubber and a boron compound (boron carbide) contained in the silicon rubber. The shielding member 8 can easily be formed into a desirable shape and has a desirable neutron shielding effect even when formed into a thin plate shape as will be described later. The shielding member 8 may contain, for example, at least one of gadolinium, gadolinium compound, cadmium and cadmium compound, each of which is superior in terms of neutron shielding effect, other than boron or boron compound. The shielding member 8 may comprise cellophane which has adsorbed boron. On the other hand, the gamma shielding member 7 comprises silicon rubber and lead powder contained in the silicon rubber. The shielding member 7 has a high gamma shielding performance even when formed into a thin plate shape. The shielding member 7 can easily be formed into a desirable shape. The shielding member 7 may comprise, for example, at least one of tungsten and tungsten compound other than lead compound, or may comprise a lead plate, lead foil or the like.

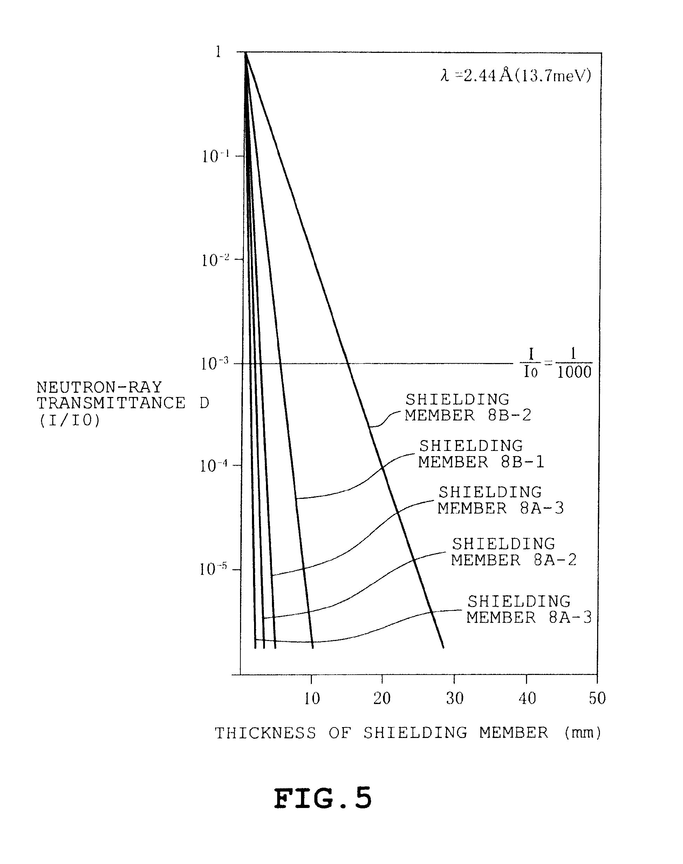

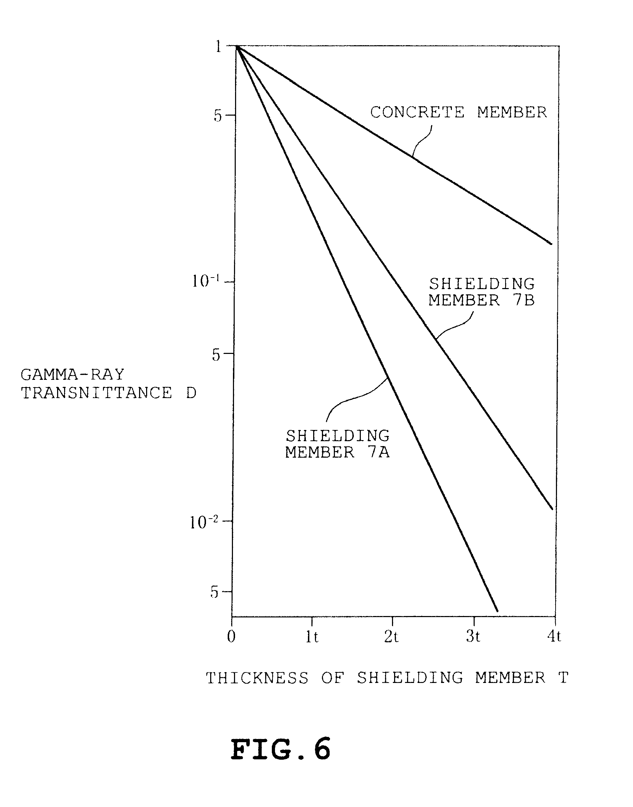

FIGS. 5 and 6 are single logarithmic charts showing the relationship between the thicknesses of the shielding members and transmittance of neutron rays and gamma rays (see a catalog of radiation shielding materials issued by Ask Sanshin Engineering Corp., Ltd.) Firstly, 8A-1, 8A-2 and 8A-3 in FIG. 5 show shielding members containing 40%, 20% and 10% gadolinium oxide in silicon rubber, respectively. 8B-1, 8B-2 and 8B-3 show shielding members comprising boron compounds having different content rates in silicon rubber, respectively, the charts showing the shielding effect against thermal neutron ray. It can be understood that the thermal neutron ray transmittance is exponentially reduced with increase in the thicknesses of the shielding members 8A-1 to 8B-2, with the result that the shielding members 8A-1 to 8B-2 have a superior neutron shielding performance.

On the other hand, reference symbols 7A and 7B in FIG. 6 show shielding members each comprising silicon rubber and tungsten powder and lead powder respectively. FIG. 6 shows shielding effects measured with respect to the shielding members 7A and 7B and a concrete member by the use of $^{60}$Co radiation source. As shown, each of the shielding members 7A and 7B has a higher gamma shielding performance than the concrete member and the gamma ray transmittance of each shielding member 7A or 7B shows an exponential attenuation tendency corresponding to the increase in the thickness T in the same manner as described above. More specifically, when $I_0$ is gamma-ray intensity incident on the shielding member, I is an intensity of gamma-ray emitted from each shielding member, $\mu$ is a linear absorption efficiency, and T is a thickness of each shielding member, $I = I0 \times \exp(-\mu T)$, and accordingly, the transmittance D of gamma-ray is shown by the following equation:

$$D = \exp(-\mu T).$$

The transmittance D of the thermal neutron ray and thicknesses of the shielding members 8A-1 to 8B-2 also satisfy the above equation, whereby a correlationship can be obtained. Since the transmittance of radiation including gamma-ray or neutron-ray varies according to radiation energy, it is preferable that a material having a high shielding effect corresponding to the energy is used.

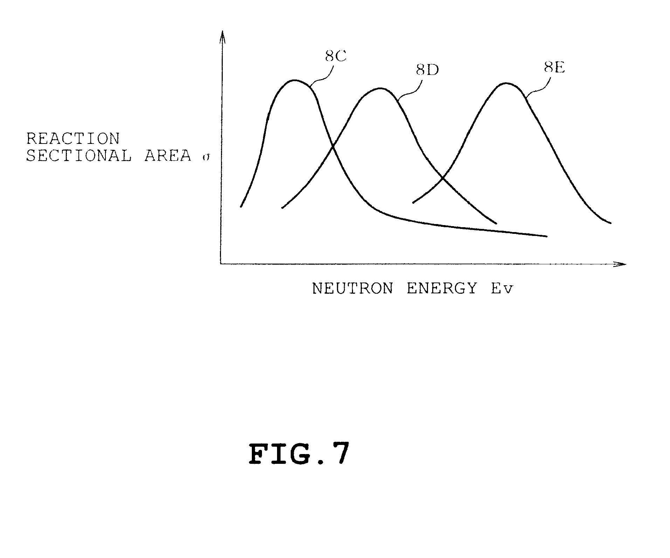

FIG. 7 is a schematic graph to explain the relationship between neutron energy and absorption cross-section o of each of the materials 8C, 8D and 8E. For example, of a low energy region containing thermal neutron at or below 0.025 eV (a left region in FIG. 7) to a high energy region containing fast neutron at or above 100 keV (a right region in FIG. 7), material 8C has a peak of absorption cross-section in the low energy region, and material 8E has a peak of absorption cross-section in the intermediate energy region and material 8. Thus, since materials 8C to 8E have individual energy regions in which the materials are superior in an absorption action, the shielding members are effective for shielding of neutron in a wide energy range from thermal neutron to fast neutron when the shielding members 8C to 8E are used together. Accordingly, neutron-ray can efficiently be shielded over a wide energy range when each layer 8a of the neutron-ray shielding member 8 comprises a plurality of materials (exemplified boron compound differing from each other in neutron energy that shows the peak absorption cross-area. On the other hand, for example, when the neutron energy range is limited to the thermal neutron-ray region, a high shielding effect corresponding to the energy can be achieved even when the layer 8a comprises only the material 8C (a boron compound, for example). When each layer 7a of the gamma-ray shielding member 7 comprises a plurality of materials each of which has a larger absorption cross-area and differs in gamma-ray energy that shows a peak absorption area (exemplified lead and other materials), too, gamma-ray can efficiently be absorbed over a wide energy range.

The aforesaid 26 layers of the laminate 2 in the embodiment are divided according to shielding characteristics of the materials composing the shielding members 7 and 8 and the radiation energy and net amount of radiation in an environment in which the RFID tag is used (the facility 27 such as a thermal neutron reactor, for example). More specifically, the layers 7a and 8a of the shielding members 7 and 8 are configured by the above-described materials corresponding to neutron or gamma energy, and the thicknesses of the shielding members 7 and 8 (that is, the numbers of the layers 7a and 8a of the shielding members 7 and 8) are set for every material according to gamma-ray or neutron-ray intensities as an amount of radiation. Consequently, the RFID tag 1 can achieve a high shielding effect against gamma rays and neutron rays while the thicknesses of the shielding members 7 and 8 are rendered as small as possible respectively. Thus, the RFID tag 1 can be said to be capable of achieving a practical level of radiation-resistance characteristic and downsizing as obvious from FIG. 5 and the like. Although radiation includes alpha rays and beta rays as well as gamma and neutron rays, the alpha and beta rays have relatively lower transparent actions and accordingly shielded by the surface layer of the laminate 2 of the RFID tag 1. The exterior resin 9 thus functions as a shielding member for shielding from alpha and beta rays.

The RFID tag 1 according to the embodiment is disposed in the laminate 2 so that the RFID circuit 4 is covered by the shielding members 7 and 8 and the exterior resin 9 shielding from radiation in the laminate 2. According to this configuration, since the entire circuit including the memory 15 of the RFID circuit 4, the control 16 and the communication 17 is covered by the shielding members 7 and 8 and the exterior resin 9, occurrence of data error in the RFID tag 1 can be suppressed even under a specific environment where the RFID tag 1 is exposed to radiation. In other words, the RFID tag 1 is shielded from radiation in all the aforementioned cases (1) to (3) which are regarded as causes of data error, whereby occurrence of data error can be prevented. Thus, since the antenna 3 is provided on the laminate 2 so as to be communicable with exterior while the RFID tag 1 has a radiation resistance characteristic, the RFID tag 1 can normally perform data communication in the non-contact manner. Consequently, the RFID tag 1 can realize high efficiency in facility maintenance and establishment of traceability and the like.

Since the laminate 2 has the gamma ray shielding member 7 for shielding from gamma rays and the neutron ray shielding member 8 for shielding from neutron rays, the laminate 2 can effectively shield from the gamma and neutron rays each of which has a particularly higher transmittance.

Since the thicknesses of the shielding members 7 and 8 of the laminate 2 are set individually according to an amount of radiation, a suitable material and thickness of each of the shielding materials 7 and 8 can be selected in view of gamma and neutron rays contained in radiation, whereby a desired shielding performance can be ensured and the shielding members 7 and 8 and accordingly, the entire RFID tag 1 can be downsized.

The numbers of shielding members 7 and 8 to be stuck are set individually of the shielding members 7 and 8 according to an amount of radiation. According to this, a suitable material and thickness of each of the shielding materials 7 and 8 can be selected according to an amount of radiation, whereby a desired shielding performance can be achieved by a simple configuration of the stacking of the shielding members 7 and 8 and accordingly, the efficiency in manufacture and cost reduction can be achieved.

Since the layers 7a and 8a of the shielding members 7 and 8 are made of respective materials according to radiation energy, the RFID tag 1 can be well shielded from radiation according to energy ranges of gamma and neutron rays in usage environment of the RFID tag 1. Furthermore, when the layers 7a and 8a of the shielding members 7 and 8 are made of respective materials according to radiation energy (in other words, each of the layers 7a and 8a is made of a material according to radiation energy), a high shielding effect and suitable shielding structure against radiation can be achieved, whereupon a practically beneficial RFID tag can be obtained.

Since the antenna 3 is provided outside the shielding members 7 and 8, communication with exterior in the non-contact manner can reliably be executed. There is a possibility that electric wave transmittance may be blocked by the shielding members, when an antenna is covered with the shielding material as is different from the foregoing embodiment. The laminate 2 has the first laminate parts 5 sandwiching the RFID circuit 4 from above and from below and vertically stacked and the second laminates 6 surrounding the sides of RFID circuit 4 and stacked in the direction differing from the direction in which the laminate parts 5 are stacked. Accordingly, the first and second laminate parts 5 and 6 can shield from radiation incident on the RFID tag from every direction, whereupon occurrence of data error can effectively be suppressed.

The laminate 2 comprises the multilayer substrate formed by stacking at least a plurality of shielding members 7 and 7, and the RFID circuit 4 is housed in the multilayer substrate. In this multilayer mounting structure, the wiring material 11 connecting between the antenna 3 and the RFID circuit 4 can be provided as a conductive layer or via hole 11a in a relatively simpler manner, and accordingly, the laminate 2 can be configured at low costs. Although not shown, when lead foils or the like are employed in the shielding member 7, instead of the layer 7a, the insulation unit such as the insulation layer is provided only in the periphery of the wiring material 11.

Since the RFID tag 1 is of the active type in which the multilayer substrate incorporates a power supply to emit electric waves, the RFID tag 1 has a longer communication distance than the passive type and can improve the stability of communication, and safer and more reliable data can be detected under radiation environment. According to this, furthermore, the detection unit detecting external environment, such as the sensor 12, can be provided on the multilayer substrate. The detection unit can obtain status of equipment and an operation status of the facility without measurement at cite by the operator.

The laminate 2 includes at least one of lead, lead compound, tungsten and tungsten compound as the material composing the gamma ray shielding member 7. The laminate 2 further includes at least one of boron, boron compound, gadolinium, gadolinium compound cadmium and cadmium compound. According to this, the radiation shielding performance of the laminate 2 can be improved as high as possible. The RFID tag 1 can be rendered more suitable in practical use and downsizing of the RFID tag 1 having the radiation resistance characteristic. The shielding members 7 and 8 should be limited to these component materials, but other component materials capable of shielding from radiation can be used.

Furthermore, an affixing unit such as an adhesive layer may be provided on the underside of the laminate 2 as a mounting unit which mounts the RFID tag 1 on an object, although not shown.

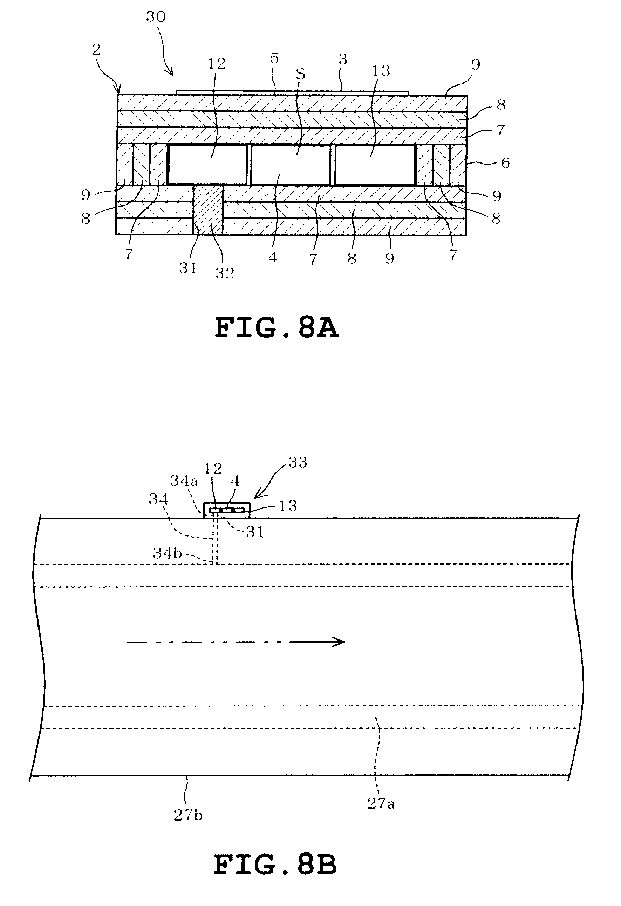

FIGS. 8A to 41 illustrate second to thirteenth embodiments. Identical or similar parts in the second to thirteenth embodiments are labeled by the same reference symbols as in the first embodiment. The description of these parts will be eliminated and only the differences will be described in the following.

<Second Embodiment>

FIG. 8A is similar to FIG. 1A, showing the RFID tag 30 according to a second embodiment. The RFID tag 30 is provided with a hole (a window) 31 spaced from the RFID circuit 4 and a heat transfer part 32 closing the hole 31. The hole 31 is located at lower portion (or an upper portion) of the first laminate part 5 and is formed into a cylindrical shape so as to communicate between the shielding space S and exterior. The heat transfer part 32 serving as a detection unit is made of a synthetic resin material having a higher heat transfer rate than the members 7 to 9 of the laminate 2, for example. The heat transfer part 32 is exposed from the laminate 2 and is in direct contact with the temperature sensor serving as the sensor 12. In the above-described configuration, the RFID tag 30 is affixed to an object to be measured so that the heat transfer part 32 is thermally brought into contact with the surface of the object, for example. As a result, the surface temperature of the object can accurately be detected.

FIG. 8B shows an RFID tag 33 which has a configuration partially different from that of the RFID 30 according to the second embodiment. The RFID tag 33 is attached to piping 27a provided with a heat insulator 27b. The heat transfer part 34 of the RFID tag 33 has one end 34a that is in contact with the sensor 12 in the hole 31 and the other end 34b that extends outward from the sensor 12 so as to be brought into direct contact with the surface of the object (piping 27a). The heat transfer part 34 serving as the detection unit is covered with a covering member (not shown) having a lower heat transfer rate than the heat transfer part 34. Accordingly, the RFID tag 33 is disposed on the outer periphery of the heat insulator 27b, and the end 34b of the heat transfer part 34 is inserted through the heat insulator 27b, whereby the end 34b can be brought into direct contact with the surface of the piping 27a. According to this, the RFID tag 33 can be mounted to an optional position, and the surface temperature of the object spaced from the mounting position can be detected more accurately.

<Third Embodiment>

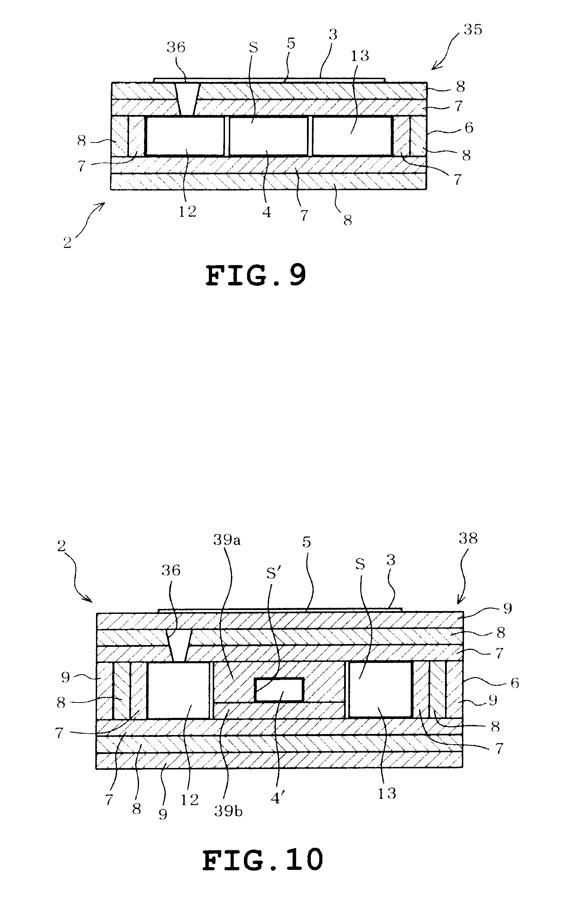

FIG. 9 illustrates an RFID tag 35 according to a third embodiment and is similar to FIG. 1A. The external resin 9 is eliminated from the laminate 2 of the RFID tag 35. The shielding members 7 and 8 are provided with the hole (the window) 36 which exposes the sensor 12 at a location spaced away from the RFID circuit 4. The hole 36 communicates between the shielded space S and exterior at an upper side of the first laminate part 5, for example, and is formed into a basin-like shape having the outer side wider than the shielding space S side. The sensor 12 of the RFID tag 35 comprises a radiation sensor or a sensor including an optical unit. More specifically, when the sensor 12 comprises a radiation sensor, the level of radiation can be detected through the hole 36 in the shielded space S. When the sensor 12 including the optical unit comprises an optical ranging sensor, light incident through the hole 36 in the shielded space S is received as a reflected light, whereby a distance to an object to be measured, such as the facility 27, can be detected. The alpha and beta rays can be shielded by the shielding member 8 serving as an outer layer.

<Fourth Embodiment>

FIG. 10 illustrates an RFID tag 38 according to a fourth embodiment and is similar to FIG. 1A. Ingots 39a and 39b covering an RFID circuit 4' are housed in the shielded space S of the RFID tag 38. Each of the ingots 39a and 39b is made of lead, for example. The ingot 39a is formed into a flat plate shape, and the ingot 39b has a recessed housing portion S' in the central underside. The ingots 39a and 39b constitute a part of the laminate 2 as a two-division gamma ray shielding member. The RFID circuit 4' has the same function as the RFID circuit 4 and is mounted on a substrate (not shown). Thus, the RFID tag 38 incorporates the ingots 39a and 39b thereby to compensate for the shielding performance of the gamma ray shielding member 7 by a simpler construction.

The component materials and shapes of the ingots 39a and 39b may suitably be changed according to the usage environment and the shielding performance to be required. Furthermore, the hole 36 of the shielding members 7 and 8 is covered by the external resin 9, and the sensor 12 comprises a radiation sensor in the laminate 2 of the RFID tag 38. More specifically, in the case of the sensor comprising the optical unit as in the third embodiment, the hole 36 needs to be formed so as to extend through the laminate 2 so as not to block light in the laminate 2 or an external resin (not shown) having translucency needs to be used instead of the eliminated external resin 9. However, the hole 36 extending only through the shielding members 7 and 8 is enough when the radiation sensor is used as in the fourth embodiment.

<Fifth Embodiment>

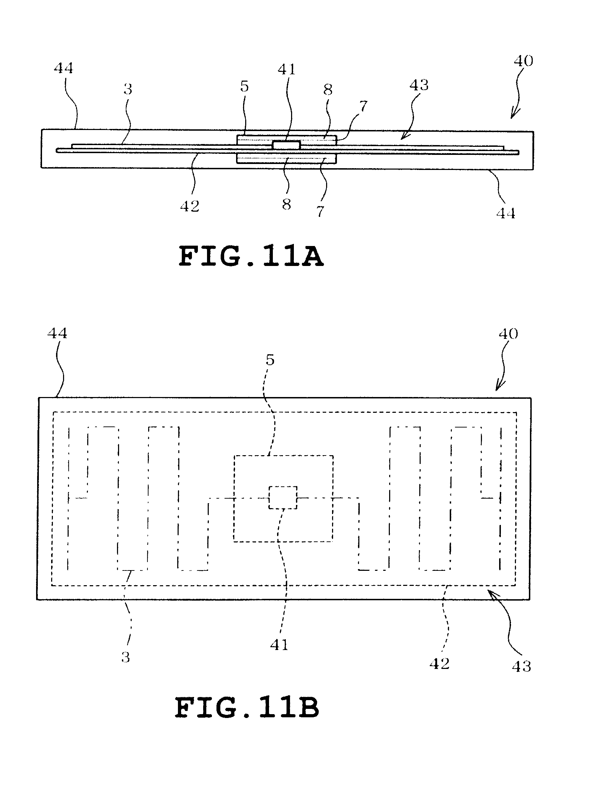

FIGS. 11A and 11B illustrate an RFID tag 40 according to a fifth embodiment and are similar to FIGS. 1A and 1B respectively. The RFID tag 40 is of a passive type which receives electric waves from exterior by the antenna 3 (see FIG. 11B) and operates with the received electric waves serving as an energy source and generates electric waves from the energy. The RFID circuit of the RFID tag 40 comprises an IC chip 41 including functions of a non-volatile storage unit, a communication unit and the like put into one chip. Differing from the RFID circuit 4, the RFID circuit 40 is not provided with the external I/F 18 and the like. The IC chip 41 and the antenna 3 are mounted on a film base material 42 comprising a PET film and constitute an inlet 43 together with the film base material 42. The inlet 43 is provided with the first laminate 5 which sandwiches the IC chip 41 from above and form below and is vertically stacked. The external resin 9 is eliminated from the first laminate 5 and is covered by a pair of upper and lower cover members 44 which cover via an adhesive layer (not shown) an entire inlet 43. The RFID tag 40 is configured into a partially covering structure that covers only the IC chip 41 of the inlet 43 with the shielding members 7 and 8 of the first laminate 5 thereby to partially shield from radiation. The antenna 3 is disposed so as to be exposed from the first laminate 5. Accordingly, the RFID tag 40 can be applied to known RFID inlets. Thus, the RFID tag 40 can simply be configured at low costs. Furthermore, since the RFID tag 40 is operable without a power source being incorporated, the RFID tag 40 is suitable for long-term facility control, for example.

<Sixth Embodiment>

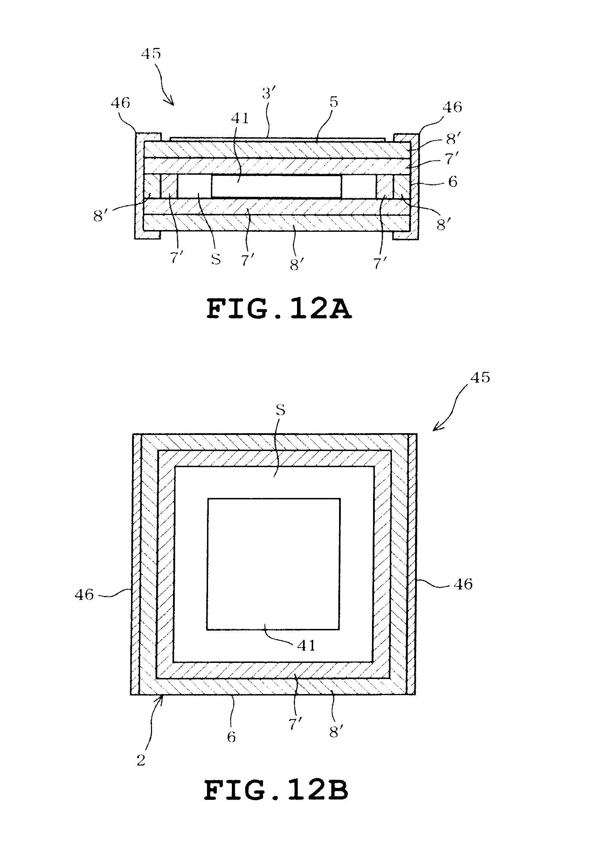

FIGS. 12A and 12B illustrate an RFID tag 45 according to a sixth embodiment and are similar to FIGS. 1A and 1B respectively. The RFID tag 45 has a first laminate 5 including two inner upper and lower gamma-ray shielding members 7' and two outer upper and lower neutron-ray shielding members 8', thereby being formed into a four layer structure. Each of the shielding members 7' and 8' comprises a single sheet-like (thin plate shaped) material. The shielding members 7' and 8' are bonded together by an adhesive layer such as a hot-melt type (bonding means). As shown in FIG. 12B, a second laminate 6 of the RFID tag 45 comprises a pair of inner and outer shielding members 7' and 8' which are each formed into a rectangular frame shape and are bonded together by the hot melt into a concentric form. Furthermore, the RFID tag 45 is provided with a pair of bonding members (bonding means) 46 each of which has a generally C-shaped section and which sandwich both ends of the first laminate 5 together with the second laminate 6, bonding the ends integrally. The aforementioned hot melt or the like may be used as bonding means to bond the first and second laminates 5 and 6 together, instead of the bonding members 46.

The RFID tag 45 is of the passive type as in the fifth embodiment, and a coil-like antenna 3' (shown only in FIG. 12A) is provided outside the shielding member 8'. Furthermore, an IC chip 41 of the RFID tag 45 is formed into the one-chip RFID circuit in the same manner as the IC chip 41 as shown in FIG. 11. The IC chip 45 is enlarged in FIG. 12 for easiness in explanation. Thus, the RFID circuit of embodiment includes the IC chip 41 integrated into a one-chip integrated circuit element and the RFID circuit 4, 4' including various electronic parts or components, such as the memory 15, mounted on a printed circuit board. The RFID circuit configures any circuit functioning as an RFID tag by being electrically connected to an antenna irrespective of the active type and passive type.

<Seventh Embodiment>

FIGS. 13 to 32 illustrate a seventh embodiment. As described above, the RFID tags 1, 30 , 33, 35, 38, 40 and 45 of the foregoing embodiments are configured respective data carriers and are classified into three groups as shown in FIG. 13.

More specifically, the RFID tags are roughly classified into an active type RFID tag 70A which incorporates a power source used as an operating electric power for inner circuits and as electric power to return electric waves, a semi-passive type RFID tag 70B which uses an incorporated power source only as an operating electric power for inner circuits and which uses an externally received electric waves as an energy source when returning electric waves, and a passive type RFID tag 70C which does not incorporate a power source and operates with externally received electric waves as an energy source. The RFID tags 70A to 70C serve as slaves for the tag reader/writers 20A and 20B each serving as a master and incorporate a tag side control serving as a slave side control and a non-volatile storage unit for storing data.

More specifically, the above-described RFID tags 1, 30, 33 and the like are active type RFID tags 70A. In the RFID tag 70A, the control 71A serving as the tag side control corresponds to the control 16 (see FIG. 3) and controls the whole RFID tag 70A. Furthermore, the memory 72A serving as the non-volatile storage unit correspond to the memory 15.

The memory 72A is provided with a plurality of storage areas including a program area 100 in which a general program including a control program executed by the control 71A, a data area (a user area) 101 in which the aforementioned data and redundant data for correcting data error, and the like. The program area 100 further includes storage areas 103 to 105 in which a main error correcting program, an auxiliary error correcting program and a simplified error correcting program other than the storage area for the general program, as will be described later. Furthermore, the redundant data includes additional data such as data about bit pair, error detection codes, parity codes and the like, as will be described in detail later.

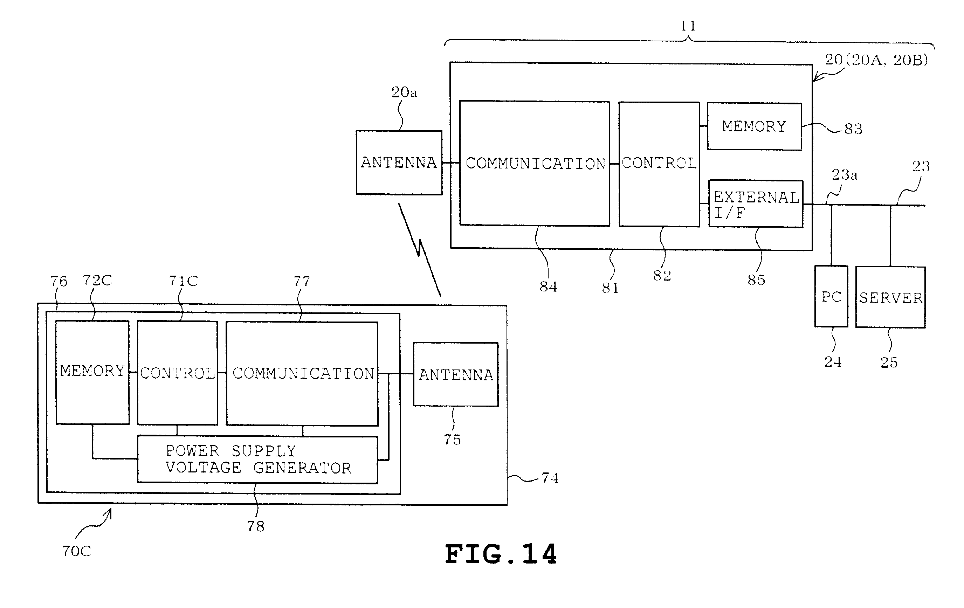

On the other hand, the RFID tags 40, 45 and the like are passive type RFID tags 70C and include a cell 13, an external I/F 18 and a sensor 12 all of which are eliminated, differing from the active type RFID tags 70A. Briefly describing the differences, the RFID tag 70C includes an antenna 75 and an RFID circuit 76 both mounted on a film base material 74 comprising a RET film as shown in FIG. 14. The RFID circuit 76 comprises a single IC chip with functions of a control circuit 71C, a memory 72C, a communication 77 and a power supply voltage generator 78 generating a power supply voltage from electric waves received by the antenna 75. The RFID circuit 76 is powered by the power supply voltage obtained by the power supply voltage generator 78. The antenna 75 and the communication 77 constitute a wireless communication unit.

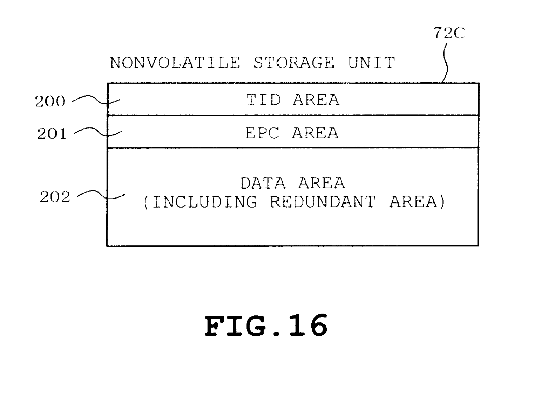

The memory 72C has a plurality of storage areas including a TID storage area 200 for storing an identification data including ID data specific to the RFID tag 70C, an EPC storage area 201 for storing an electronic product code regarding an object to which the RFID tag 70C is affixed, and a data area (a user area) 202 for storing various data obtained from the communication 77 and the like and redundant data for correcting an error in the data, as shown in FIG. 16. The ID data is identification data originally given to the RFID tag 70C and is stored in the TID storage area 200 in an unrewritable manner.

The control 71C comprises a hard logic circuit and is configured to execute predetermined processes including a process of writing into the memory 72C and a process of transmitting data stored in the memory 72A during communication with the tag reader/writer 20.

The control 71C of the RFID tag 70C may be composed of a CPU. The RFID tag 70B has a cell incorporated therein (see FIG. 13) and, on the other hand, is of the semi-passive type in which electric waves received from the tag reader/writer 20 serves as an energy source to generate electric waves. The detailed description of the semi-passive type will be eliminated.

The tag reader/writer 20 is an external electronic device serving as a master to the RFID tags 70A to 70C. More specifically, as shown in FIG. 14, the tag reader/writer 20 includes a control 82 serving as a device side control mounted on the substrate 81, a memory 83, a communication 84 and an external I/F 85 all connected to the control 82. The control 82, memory 83, communication 84 and external I/F 85 constitute a reader/writer circuit 86. The reader/writer circuit 86 is electrically connected to the antenna 20a, and the communication 84 constitutes a wireless communication unit together with the antenna 20a. The external I/F 85 is connected to a higher-level device such as the personal computer 24.

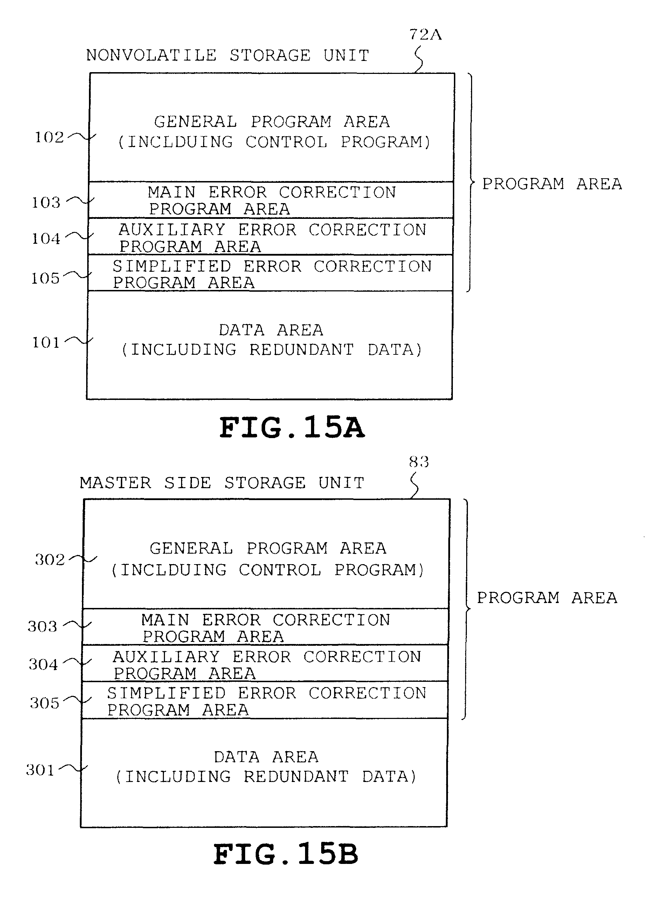

The memory 83 of the tag reader/writer 20 is provided with a plurality of storage areas including a program area 300 in which a general program including a control program executed by the control 82, a data area (a user area) 301 in which the aforementioned data and redundant data for correcting data error, and the like, as in the memory 72A of the RFID tag 70A (see FIG. 15). The program area 300 further includes storage areas 303 to 305 in which a main error correcting program, an auxiliary error correcting program and a simplified error correcting program other than a storage area 302 for the general program, as will be described later.

The control 82 serving as the master side control delivers a communication command to the communication 84 based on the control program stored in the general program storage area 302, so that an electric wave signal with a predetermined frequency, modulated with the use of transmission data in the communication 84 is transmitted from the antenna 20a, and a receipt process of demodulating the electric signal received by the antenna 20a into original data.

The memories 72A to 72C of the RFID tags 70A to 70C and the memory 38 of the tag reader/writers 20A and 20B are of a type that data is recorded by holding electric charge on a floating gate. More specifically, various non-volatile semiconductor memories such as a flash memory, an EEPROM and the like may be used as the above-described memories. The memories 72A to 72C and 83 are configured as non-volatile storage units.

The data management system 21 uses an active type RFID tag 70A (RFID tags 1a to 1c) including various sensors provided in the facility 27 as exemplified in FIG. 4. Furthermore, a passive type RFID tag 70C can be affixed to articles 27c carried into and out of the facility 27 and helmets 27d of workers. Thus, various RFID tags 70A to 70C may be applied to various articles.

According to the above-described RFID tags of the respective embodiments, a high radiation shielding effect and a suitable shielding structure can be achieved by the shielding member of the laminate. However, for example, it can be considered that in a case where the RFID tags 70A to 70C are used near a radiation source for a long period of time, data error may occur even in the configuration provided with the above-described laminate or that data error may occur depending upon an amount of radiation. More specifically, for example, an amount of electron (electric charge) injected into floating gates of memory cells arranged in a matrix in the memory 72C of the RFID tag 70C reduces by photoelectric effect resulting from incidence of gamma rays, for example. In this case, there is a possibility that data error occurs in which data changes from "1" to "0" in one direction in a memory cell. A degree of damage is classified into the following first to third stages as follows:

First stage in which damage occurs due to collision of radiation against electrons of the memory cell and there is a possibility of occurrence of data error by further radiation collision;
Second stage in which a 1-bit data error has occurred in word data comprising 8 bits in a memory cell, for example; and

Third stage in which the degree of damage of the memory 72C is large such that 2-bit or more data error has occurred in the word data and continuous data error (burst error) over a plurality of bits or 1-bit data error has dispersively occurred in a plurality of portions of storage area (random error).

The inventor then constructed a data management system which is capable of correcting errors which may occur in all stages resulting from radiation incidence. In the relation with a communication distance, a combination of types 70A to 70C of the RFID tag 70 and types 20A and 20B of the tag reader/writer 20 (see FIG. 13) is classified into:

(a) an active type RFID tag 70A with a cell and a stationary type tag reader/writer 20B;
(b) a semi-passive type RFID tag 70B and a handy type or stationary type tag reader/writer 20A or 20B; and
(c) a passive type RFID tag 70C and a handy or stationary type tag reader/writer 20A or 20B.

The following will describe error correction in the combination (c) of the RFID tag 70C and the handy type tag reader/writer 20A. The control 71C and the memory 72C of the RFID tag 70C serves as the tag side control 71C and the tag side memory 72C respectively, and the control 82 of the tag reader/writer 20A serves as the RW side control 82.

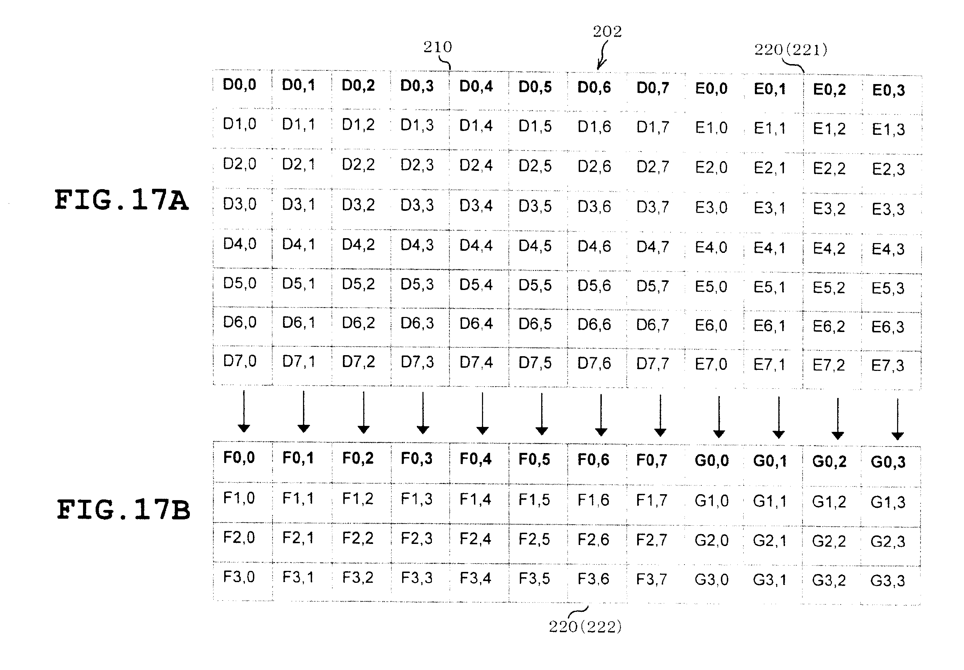

FIGS. 17A and 17B show redundant data generated for data stored in the tag side memory 72C. The data area 202 has a main data area 210 for storing main data as original data and a redundant area 220 for storing redundant data. FIGS. 17A and 17B show 8-bit main data area 210.

Redundant data stored in the redundant area 200 includes error detection codes for correcting error in the main data stored in the main data area 210. The redundant data includes a lateral first error detection code generated for every address of main data and a lengthwise second detection code generated for every same bit location.

A hamming code is used as the error detection code, for example. When the number of error correction bits regarding the hamming code is represented as "m," a code length is indicated as $2^m-1$. Accordingly, when m=4, for example, a hamming code is formed which substitutes 15-bit code term (code length) for 11-bit main data. In the embodiment, in an error detection process as will be described later, 3-bit dummy data is affixed to 8-bitwise main data (that is, top 3-bit is rendered "0") so that an error detection process is executed with an apparent 4-bit error detection code following the 11-bit main data. A parity bit may be added to the hamming code so that 2-bit error detection and 1-bit error correction are executed.

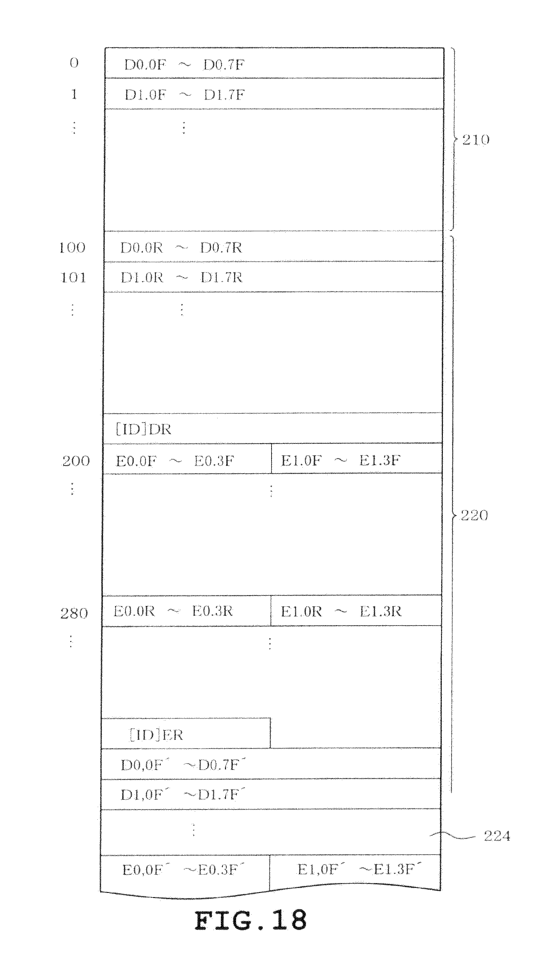

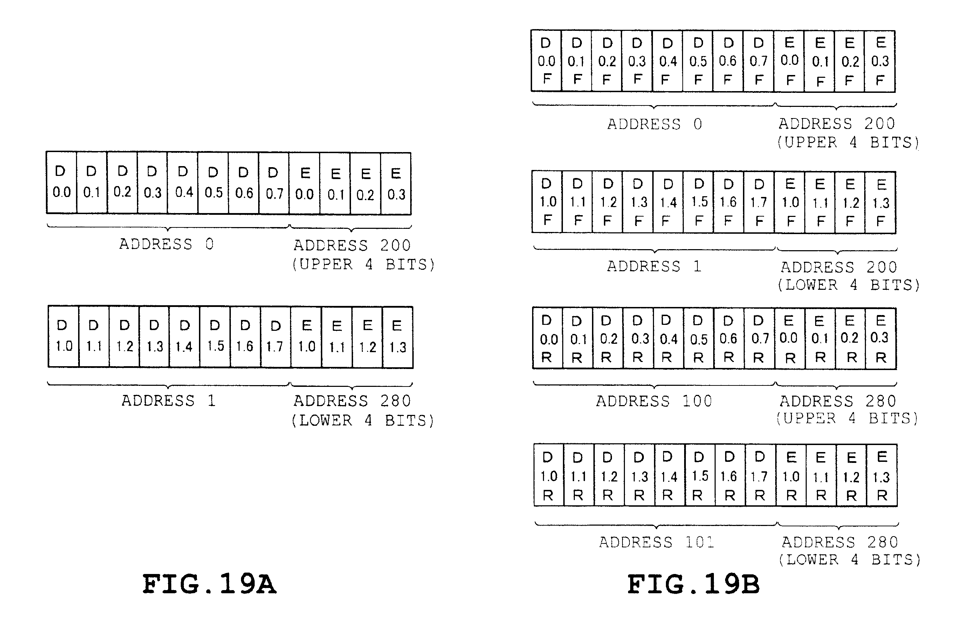

FIG. 17A shows area 210 storing the main data and area 221 storing a first error detection code (first redundant data). In these areas, when x designates a longitudinal coordinate value (address) and y designates a lateral coordinate value (bit location), main data D (x, y) and the first error detection code E (x, y) are shown in FIG. 17A. The first error detection codes E0, 1 to E0, 3 and E1, 0 to E1 and 3 are written into top 4 bits and low 4 bits (see address 200 in FIG. 18 and FIG. 19A). Accordingly, two rows of data D0, 0 to E0, 3 and D1, 0 to E1, 3 are represented by 3-byte data. Furthermore, FIG. 17B shows second error detection code F (x, y) generated for every row at the same bit locations as the main data D0, 0 to D7, 7 and second error detection code G (x, y) generated for every row at the same bit location as the first error detection code E in an area 222 storing the aforesaid second error detection codes (second redundant data) in the redundant area 220. The codes D (x, y), F (x, y) and G (x, y) as shown in FIGS. 17A and 17B are for easy explanation of data arrangement and an actual data bit arrangement is applicable to both LSB (least significant bit) first and MSB (most significant bit) first.

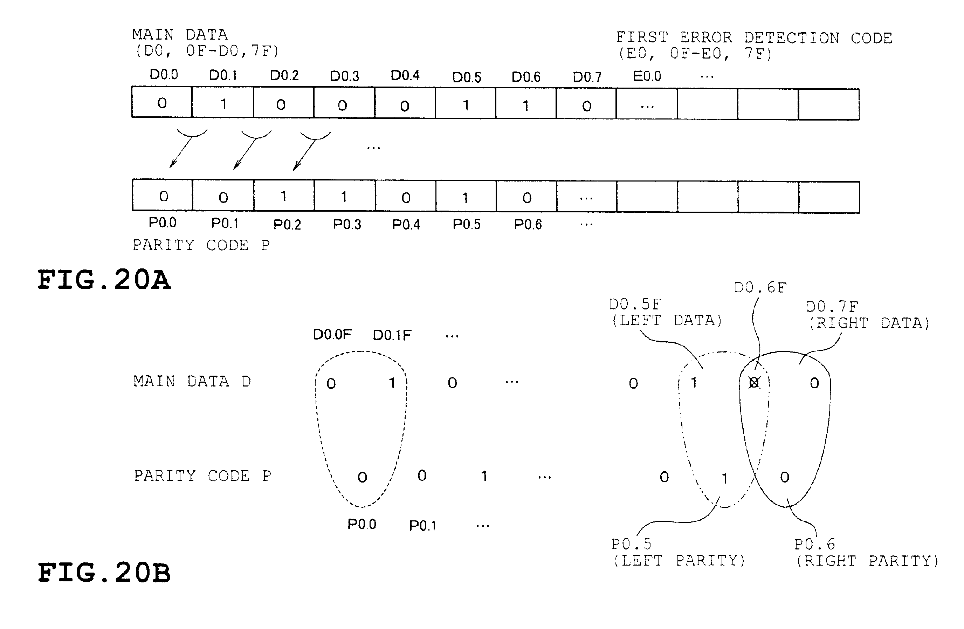

A parity code in the embodiment is added to each bit composing data according to a combination of adjacent bits. More specifically, for example, an odd parity check is carried out on the basis of parity codes. When the value indicated by main data D0 and O is 0 and the value indicated by main data D0 and 1 is 1, parity bit with the value of 0 is added (see FIGS. 20A and 20B). Accordingly, for example, the value indicated by main data D0, 0 to D0 and 7 and first error detection code E0, 0 to E0 and 3 is "01000110 ···" an odd parity code P comprising "0011010 ···" corresponding to a combination of adjacent values is generated. An error detection process and an error correction process are adapted to be carried out with respect to the main data D and the first error detection code E using the parity code P. The parity code P may be an even parity code.

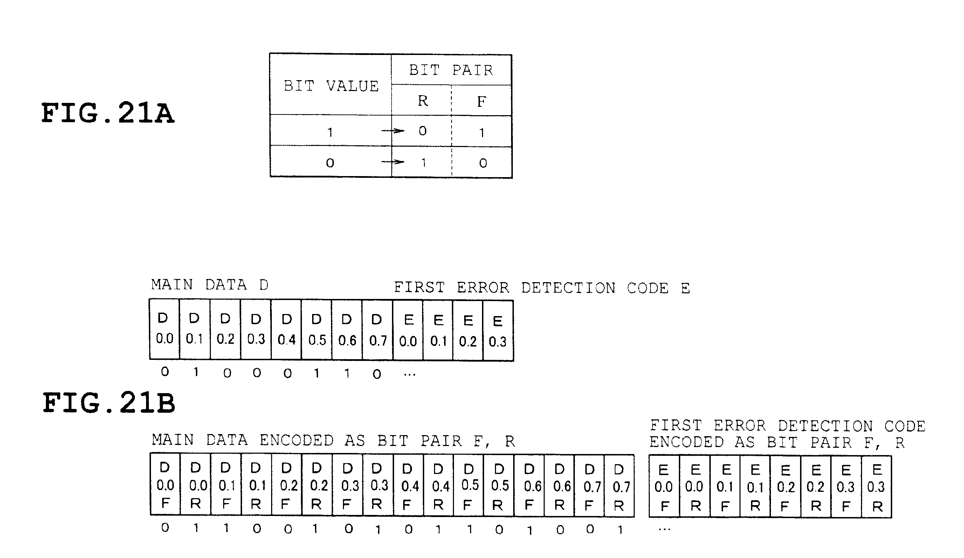

Bit pair that is one of redundant data in the embodiment is data encoded as paired bits of "01" serving as one of 1 and 0 indicated by each bit and "10" serving as the other of 1 and 0, and 1-bit data is represented as 2-bit data. More specifically, as shown in FIG. 21B, encoding is carried out to obtain bit pair of 10 indicative of 0 further indicated by main data D0 and 0 and 01 indicative of 1 further indicated by main data D0 and 1. Accordingly, when the value indicated by main data D0, 0 to D0 and 7 and the first error detection code E0, 0 to 0, 3 as shown in FIG. 21B is "01000110 ···", data D0, OF to E0, 3R comprising "0110010101101001 ···" is generated. In this case, the original value of data 0 in main data D0, 0 is one of bit pair, that is, bit 0 (indicated by F in FIG. 21A) and the other bit 1 (indicated by R) is data obtained by inverting 0.

Accordingly, as shown in FIG. 19B, of four-row data D0, OF to E1, 3R encoded as bit pair, upper first row data D0, OF to E0, 3E corresponds with main data D0, 0 to D0, 7 and first error detection code E0, 0 to E0, 3 in FIG. 19A [(D0, 0F to E0, 3F)=(D0, 0 to E0, 3)]. Upper third row data D0, 0R to E0, 3R in FIG. 19B is data obtained by inverting first row data D0, OF to E0, 3F. Furthermore, as shown in FIGS. 18 and 19B, one bit F of bit pair F, R and the other bit R of the bit pair are stored at locations having the same bit and different addresses in data area 202. In other words, encoded data D0, 0F to E0, 3F and inverted data D0, OR to E0, 3R are stored at addresses differing from each other and values indicated by corresponding bits are inverted each other.

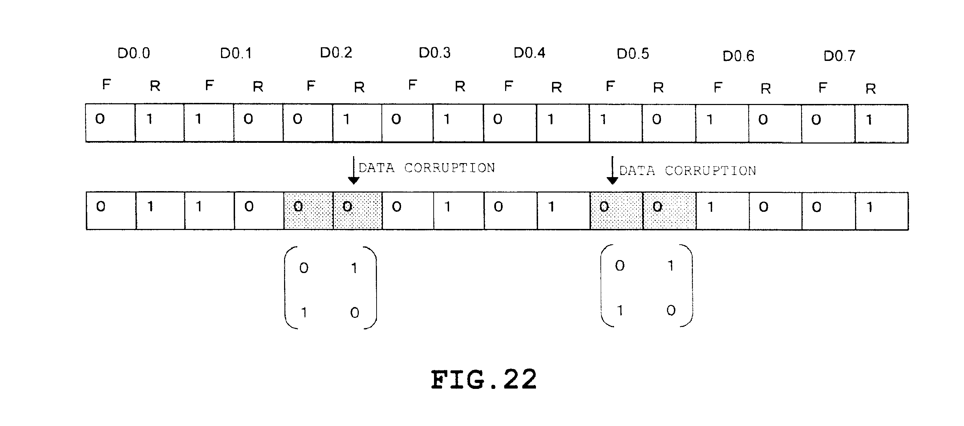

FIG. 22 exemplifies the above-mentioned data error in which part of bit values changes in one direction from "1" to "0" in main data D0, 0 to D0 and 7. More specifically, since bit pair either one of bit pair F and R includes 1, bit pair 00 (shaded parts in FIG. 22) becomes an error pattern when the aforesaid change in one direction is presupposed. As a result, the number of errors and the locations of bit pair F and R can be specified. For example, error can be detected by execution of the logical OR operation of one bit F and the other bit R in each bit pair F and R.

Differing from the above-described encoding, the values 0 and 1 indicated by each bit of data may be encoded as bit pair. Furthermore, although there is a case where the change from "0" to "1" occurs depending upon a definition of the state where a memory stores data, it is only necessary to invert "0" and "1." Accordingly, the following description is based on a premise that bit values change from "1" to "0" in one direction.

The redundant area 220 includes a multiplexed data storage area 224 for storing multiplexed data (see FIG. 18). In the embodiment, for example, bit pair F and R of main data D0, 0 to D7 and 7 is duplicated by writing bit pair F and R into both a main data area 210 and a multiplexed data storage area 224. Bit pairs F and R of the first error detection codes E0, 0 to E7 and 3 are also duplicated by writing bit pair R and R into both first error detection code area 221 and multiplexed data storage area 224. In the following description, multiplexed main data and first error detection code will be dashed as D0, OF'to D7, 7R' and E0, OF'to E7, 3R' (see FIG. 18). The first error detection code E, the second error detection code F, G and the parity code P and redundant data of these data can be multiplexed, if necessary. Furthermore, the target for which the first error detection code E, second error detection code F, G and parity code P are generated and the target to be encoded as bit pair F and R should not be limited to the description of the embodiment but can suitably be set among redundant data E, F, G and P.

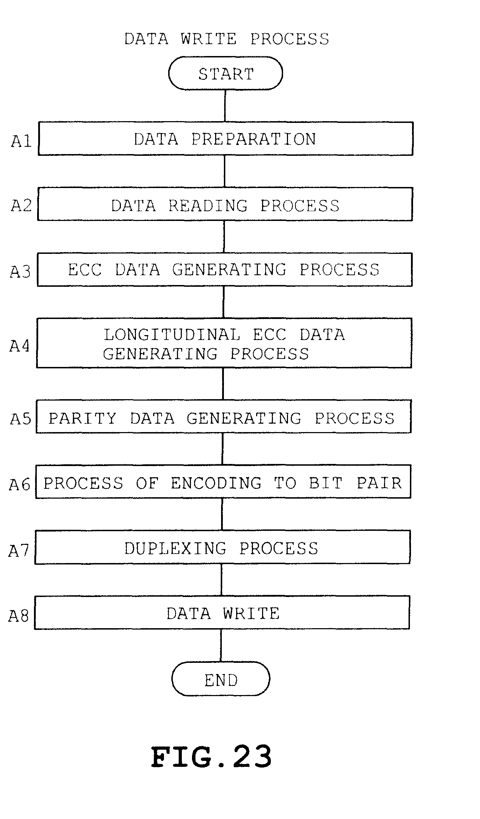

The operation of the above-described configuration will now be described with reference to FIGS. 23 to 32. FIG. 23 is a flowchart showing a process of writing data into the FID tag 70C using the handy type tag reader/writer 20A.

When the operator firstly operates an operation part (not shown) of the tag reader/writer 20A, the RW side control 82 accepts and processes data to be written, based on an operation signal input from the operation part (step A1). Before transmitting data to be written to the RFID tag 70C, the RW side control 82 reads, from the tag side memory 72C, data of all addresses other than addresses into which the write data is to be written and detects errors based on the redundant data, thereby correcting the error (step A2).

After the reading process at step A2, the RW side control 82 executes a process of generating a first error detection code E for every address regarding the main data D serving as data to be written and further generating the second error detection code F, G for every same bit location (steps A3 and A4). Subsequently, the RW side control 82 generates the parity code P corresponding to a combination of adjacent bits with respect to bits constituting the main data D and the first error detection code E (step A5). Furthermore, the values "1" and "0" indicated by each bit of the main data D, first error detection code E and parity code P are encoded as bit pair of 01 and 10 (step A6). Furthermore, bit pairs F and R of main data D and first error correction code E are duplicated at step A7, so that bit pairs F' and R' of main data D and first error detection code E are generated. Thus generated bit pairs F and R and duplicated bit pairs F' and R', second error detection codes F and G and parity code P are transmitted to be written into the tag side memory 72C (step A8), whereby the writing process with the use of the tag reader/writer 20A is ended. As a result, since various types of redundant data are stored together with bit pair F of main data D, the error detection process and the error correcting process can be executed on the basis of the redundant data.

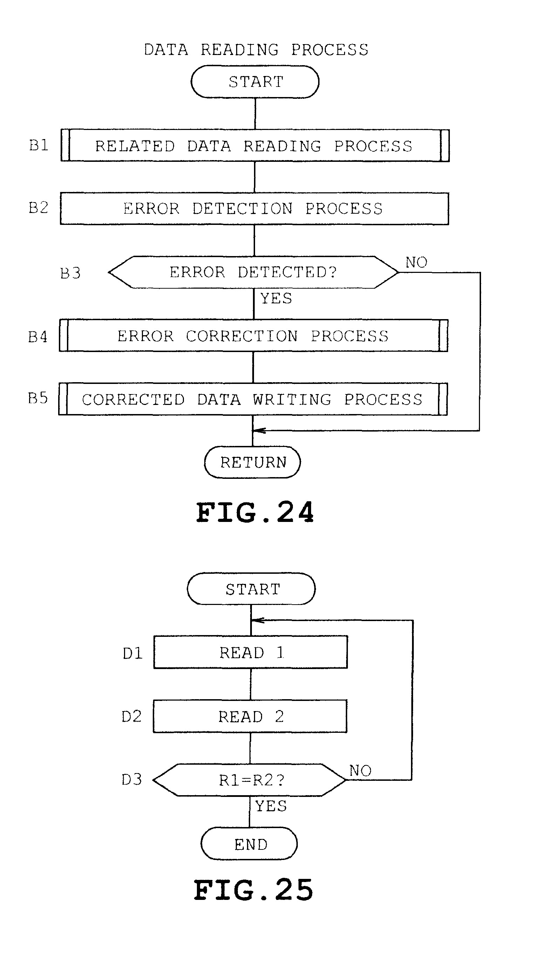

FIG. 24 is a flowchart showing a reading process executed at step A2 in the writing process.

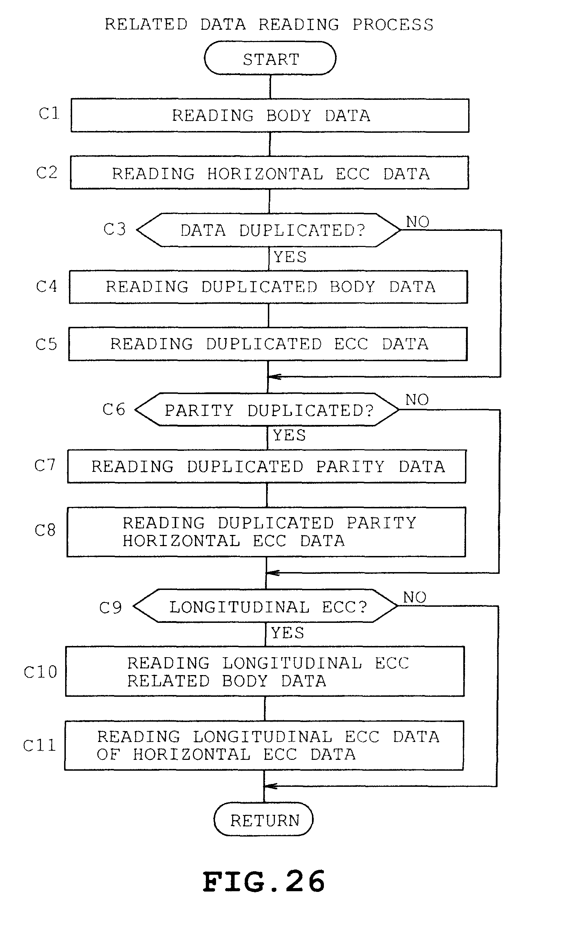

Firstly, the RW side control 82 executes a related data reading process to read data of all addresses other than addresses into which the writing data is written from the tag side memory 72C (see step B1 and steps C1 to C11 in FIG. 26). More specifically, in the related data reading process, the bit pairs F, R of main data D and first error detection code E are read from the tag side memory 72C (steps C1 and C2). Subsequently, when the bit pairs F, R of main data D and first error detection code E have been multiplexed (YES at step C3), bit pair F' and R' of main data D and first error detection code E as the multiplexed data are read from the tag side memory 72C (steps C4 and C5). Furthermore, when the parity code P has been added (YES at step C6), parity codes of the main data D and first error detection code E are read from the tag side memory 72C (steps C7 and C8. Furthermore, when the second error detection codes F and G have been added (YES at step C9), the second error detection codes F of main data D and the second error detection code G of first error detection code E are read from the tag side memory 72C (steps C10 and C11).

When determining that redundant data stored in the redundant area 220 of the tag side memory 72C is only bit pair R related to main data D and first error detection code E (NO at steps C3, C6 and C9), the RW side control 82 reads bit pair F and R related to main data D and first error detection code E at steps C1 and C2, thereafter proceeding to an error detecting process at step B2 (see FIG. 24). In the reading step at step B1, the RW side control 82 repeatedly reads data until the same data is continuously read at least twice regarding the same address. More specifically, for example, 8-bit main data D0, 0 to D0, 7 is read twice (steps D1 and D2 in FIG. 25). When the first and second data differs from each other (NO at step D3), data is read continuously twice again. That is, when data is taken out of the RFID tag 70C in the environment exposed to radiation, there is a possibility that data may be corrupted by radiation at RFID tag 70C side where data is transmitted or at the tag reader/writer 20A side where the data is received. In view of this, the RW side control 82 repeatedly obtains data until the same data is continuously read at least twice, whereupon data corruption can be prevented when data is read from the tag side memory 72C. Furthermore, memory cells can be recharged or refreshed simultaneously with the reading in data read at step B1 (steps D1 to D3) even when no error has been detected in an error detection process which will be described later (NO at step B3 in FIG. 24) and an error correction process has not been executed. Accordingly, even if electrons have been lost by radiation collision in each memory cell, the damage at the first stage can be remedied.

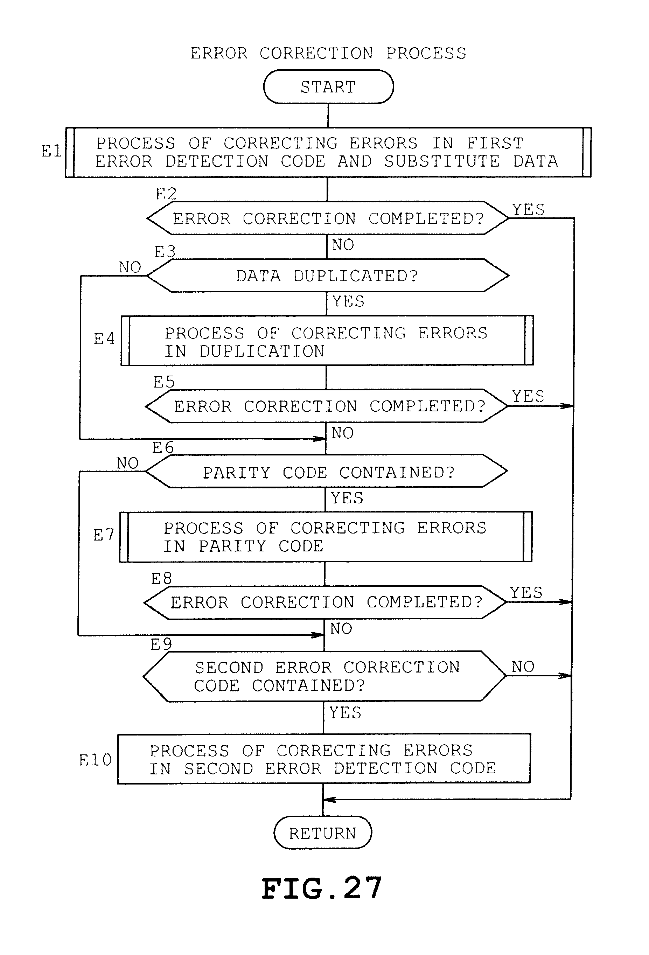

A logical OR operation is carried out regarding one bit F and the other bit R of bit pair F and R of main data D and first error detection code E at step B2. When the result of operation is 1, the RW side control 82 determines that the bit pair F and R has no error (NO at step B3). When the operation result is 0, the RW side control 82 determines that either one of bit pair F and R contains error (YES at step SB3), proceeding to an error correction process (step B4 and step E1 to E10 in FIG. 27).

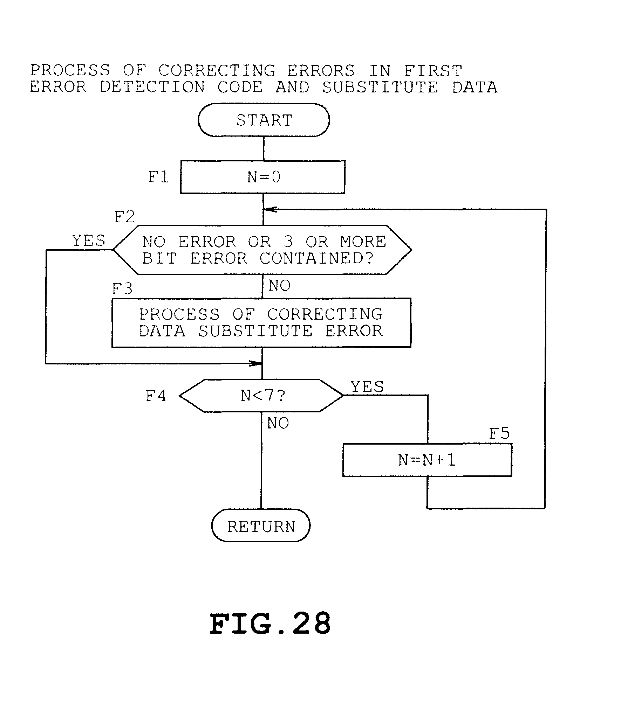

In the error correction process, a correction process is firstly carried out for every one byte regarding the bit pair F and R of main data D and first error detection code E (step E1 and steps F1 to F5 in FIG. 28). More specifically, the RW side control 82 clears a counter N for counting the number of bytes to zero (step F1) and determines whether or not the result of logical OR operation is 0 in three or more bit pairs F, R or whether or not all the results of logical OR operation are 1 based on the logical OR operation of main data D0, 0R to D0, 7R per bit (step F2). For example, as shown by shaded parts in FIG. 22, the operation result becomes 0 regarding bit pair F, R of main data D0, 2 and D0, 5 in which the combination of bit pair F, R of main data D0, 0 to D0, 7 is represented as "00." Accordingly, it is determined that bit pair F, R of main data D0, 2 and D0, 5 contains error (NO at step F2), and a process of correcting the error in the main data D0, 2, D0, 5 is carried out (step F3). In this case, data 01 or 10 is sequentially substituted for bit pairs F, R of main data D0, 2 and D0, 5. An error detecting process is carried out regarding substituted main data D0, 0F to D0, 7F, D0, 0R to D0, 7R on the basis of first error detection codes E0, 0F to E0, 3F, E0, 0R to E0 and 3R. In this case, substituted data for bit pairs F, R of the main data D0, 2, D0, 5 has four substitute patterns, that is, 01 and 10 in bit pair F, R of main data D0, 2 and 01 and 10 in bit pair F, R of main data D0, 5 (see FIG. 22). Accordingly, regarding 2-bit data error within 1-byte, when the error detection process is carried out at most four times based on the aforesaid substitute data and first error detection code E, no error is detected such that the error can be corrected (a first error correction process).

When 0-th byte error has been corrected or an affirmative determination has been made at step F2, the counter N is incremented (step F5) since processing has been finished till the seventh byte, and it is also determined whether or not there are three or more bit pairs F, R each containing data error on the basis of the result of logical OR operation of main data D1, 0R-D1, 7R regarding first byte main data D1, OF to D1, 7F (or there is no error) (step F2). When one or two bit pairs F, R contain data error, substitute data is sequentially substituted, an error correcting process is carried out on the basis of first error detection codes E1, OF to E1, 3F, E1, 0R to E1, 3R (step F3). Thus, steps F2 to F5 are repeatedly executed so that the error detection process and the error correction process are also executed for every byte regarding the main data D of the first or subsequent bytes. When error correction at seventh byte has been finished (NO at step F4), the RW side control 82 proceeds to step E2 in FIG. 27. When determining at step E2 that data error has been resolved by the foregoing error correction process regarding all the data read from the tag side memory 72C (YES), the RW side control 82 writes the data with no error into the tag side memory 72C (returns to step B5 in FIG. 24), ending the process. Although the process of correcting errors in main data D at steps F1 to F5 has been described, the error detection is executed on the basis of the bit pair F, R regarding the first error detection code E, and the error correction process is executed on the basis of substitute data for every row at the same bit location and the second error detection code G (see steps I1 to I5 as will be described later). More specifically, steps F1 to F5 are carried out after execution of error correction process regarding the first error detection code E.

On the other hand, when the main data D or data of the first error detection code E contains 3 or more bit of error in 1 byte (YES at step E2 in FIG. 27) or other data contains error, the RW side control 82 determines whether or not data is multiplexed (step E3). When the data is multiplexed, a correction process is executed regarding multiplexing (step E4, steps G1 to G8 in FIG.

29). More specifically, the error detection process and error correction process are executed for every 1 byte regarding the multiplexed main data D' and first detection code E' in the same manner as in step E1 (that is, steps F1 to F5). When determining that the error has been resolved regarding all the data read from the tag side memory 72C as the result of the correction process (YES at step G2), the RW side control 82 returns to step E5 in FIG. 27. When determining at step E5 that the error has been resolved (YES), the RW side control 82 writes the data with no error into the tag side memory 72C (returns to step B5 in FIG. 24), ending the process.

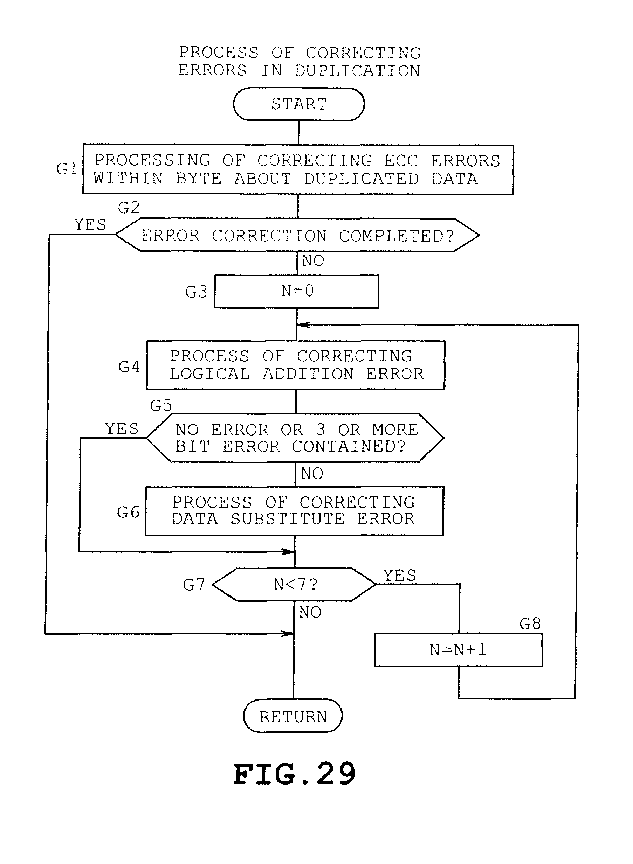

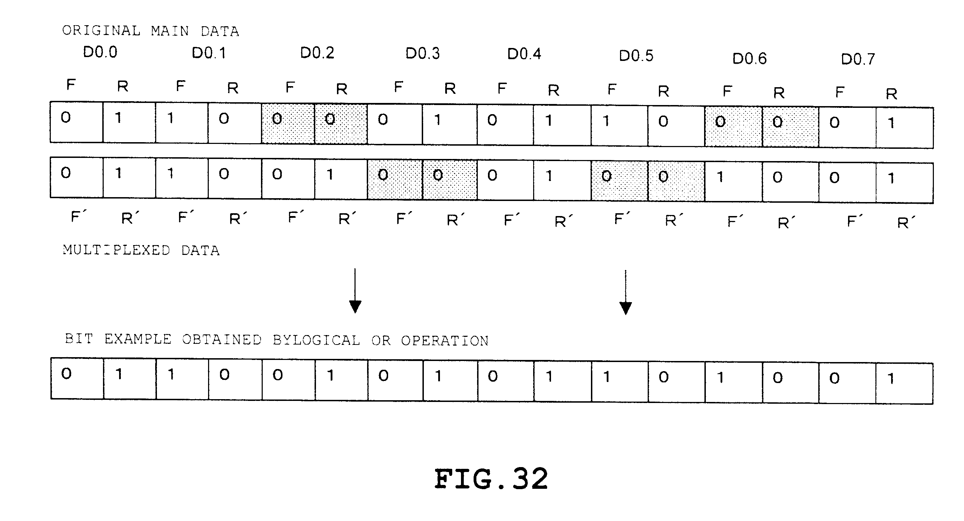

When determining at step G2 in FIG. 29 that the error has not been resolved (NO), the RW side control 82 clears the counter N for counting bytes to 0 (step G3). At step G4, the logical OR operation is carried out for every bit corresponding between the original main data D and the multiplexed main data D', and the logical OR operation is carried out for every bit corresponding between the first error detection code E and the multiplexed first error detection code E' (step G4). For example, in FIG. 32, the logical OR operation is carried out for every bit corresponding between the upper main data D0, 0F to D0, 7F and the lower multiplexed main data D0, 0F' to D0, 7F'. FIG. 32 also shows main data D0, 0R to D0, 7R and D0, 0R' to D0, 7R' for the convenience of explanation. As shown by shaded parts in the figure, even when bit pair F, R of main data D0, 2 and D0, 6 and bit pair F', R' of multiplexed main data D0, 3 and D0, 5 are "00" such that data error has occurred, a bit row in which data error has been repaired can be obtained as the result of the logical OR operation of the bit when correct data is present at the same bit location.

After the error correction process at step G4, the RW side control 82 carries out the logical OR operation of main data D0, 0R and D0, 7R for every bit regarding main data D0, 0F to D0, 7F, determining whether or not the result of operation is 0 in 3 or more bit pairs F, R or all the results of operation are 1 (step G5). Even when the bit row contains one or two errors (NO), the error detection process is carried out on the basis of the substitute data and the first error detection code until no error is detected, whereby the errors are corrected.

When 0-th byte error has been corrected or an affirmative determination has been made at step G5, the counter N is incremented (step G8) since processing has been finished till the seventh byte (YES at step G7), a logical OR operation is carried out for every bit corresponding between first byte main data D1, 0F to D1, 7F and multiplexed main data D1, OF' to D1, 7F' (step G4). When 2 or more bit (or 1 bit) error is contained in the bit row obtained from the logical OR operation, substitute data is sequentially substituted so that the error correcting process is executed (steps G5 and G6). Thus, steps G4 to G8 are repeatedly executed so that the error detection process and the error correction process are also executed for every 1 byte regarding the first and subsequent byte main data D. When finishing seventh byte error correction (NO at step G7), the RW side control 82 proceeds to step F5 in FIG. 27. When determining that the error has been resolved regarding all the data read from the tag side memory 72C as the result of the correction process (YES), the RW side control 82 writes the data with no error into the tag side memory 72C (returns to step B5 in FIG. 24), ending the process.

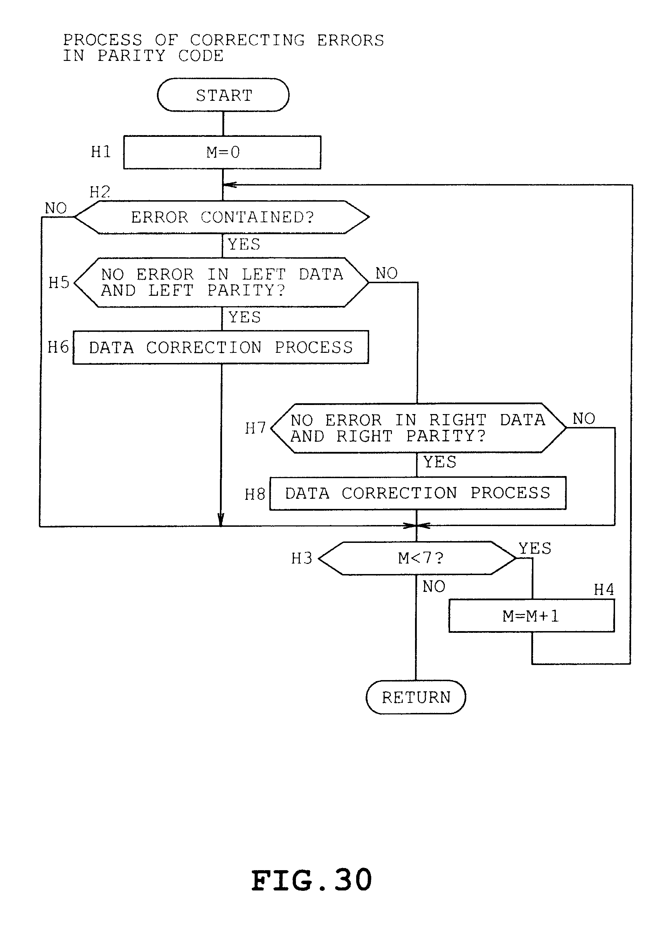

When error is still contained in the data after the error correction process relating to the aforementioned multiplexing (NO at step E5), the RW side control 82 determined whether a parity code has been added (step E6). When the parity code has been added (YES), a correction process relating to the parity code P is carried out (step E7 and steps H1 to H8 in FIG. 30). More specifically, the RW side control 82 clears the counter M for counting the number of bytes to zero (step H1) and corrects data of the address as an object to be corrected, for example, relating to main data D0, 0F to D0, 7F. More specifically, the value 0 indicated by the main data D0, 0F is determined by an odd parity check (parity bit P0, 0) to contain no error in relation to value 1 indicated by neighbor data D0, 1F, as surround by broken lines in FIG. 20B (NO at step H2). Following the 0-th bit, the RW side control 82 increments the counter M to execute processing at the first bit (steps H3 and H4) and carries out the odd parity check for the main data D0, 1F in the same manner as described above step H2. Thus, in the course of repeated execution of steps H1 to H4, when determining that the main data D0, 6F contains error based on the odd parity check (YES at step H2; and see FIG. 20B), the RW side control 82 determines whether or not the left data D0, 6F and left parity P0, 5 contain errors (step H5). When neither data D0, 6F or P0, 5 contains error, the values of D0, 6F are corrected on the basis of a parity bit P0, 5 (step H6). In this regard, even in the case where either left data D0, 6F or left parity P0, 5 contains error (NO at step H5), the values of D0, 6F can be corrected on the basis of parity bit P0, 6 (step H8) when right data D0, 7F and right parity P0, 6 contain no error (NO at step H7). Thus, when the processing of addresses as the object for correction has been finished up to seventh byte (NO at step H3), the RW side control 82 proceeds to step E8 in FIG. 27. When determining that data error has been resolved by the foregoing error correction process regarding all the data read from the tag side memory 72C (YES), the RW side control 82 writes data with no error into the tag side memory 72C (returns to step B5 in FIG. 24), ending the process.

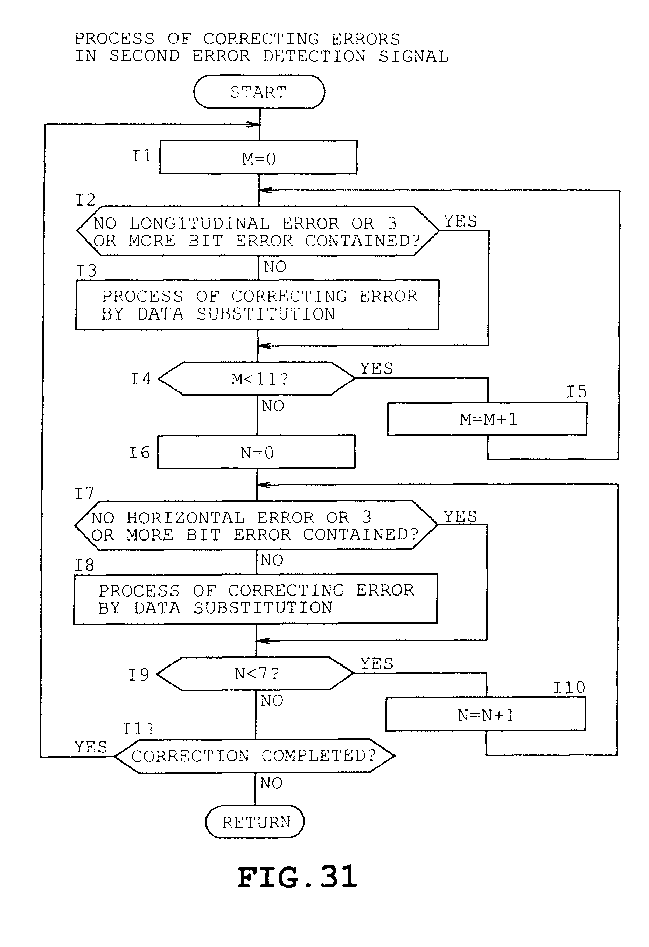

When error is still contained in the data after the error correction process relating to the aforementioned parity code (NO at step E8), the RW side control 82 determined whether second error detection codes F, G have been added (step E9). When the second error detection codes have been added (YES), an error correction process relating to the second error detection codes F, G is carried out (step E10 and steps I1 to I11 in FIG. 31). In this error correction process, the RW side control 82 clears the counter M for counting the number of bytes to zero (step I1) and executes a process of detecting errors in each one of rows assuming the same bit location regarding data to be corrected. More specifically, the RW side control 82 executes a logical OR operation of a row of main data D0, 0F to D7, 0F (see FIG. 17A) and a row of main data D0, 0R to D7, 0 forming bit pairs in each one of bits, thereby determining whether or not 3 or more bit error is contained (step I2). When neither condition is satisfied or when 2 or 1 bit error is contained (NO), the RW side control 82 executes a process of sequentially substituting the substitute data for the bit pair F, R of the main data D0, 0 to D7, 0 in which the error has been detected and correcting the error on the basis of the second error detection codes F0, 0F to F3, 0F, E0, 0R to E3, 0R (step I3, a second error correction process).

When 0-th byte error has been corrected or an affirmative determination has been made at step I2, the counter N is incremented (step I5) since processing has not been finished till the eleventh bit (YES at step I4), and an error detection process is also executed on the basis of bit pair F, R for each one of the rows assuming the same location regarding first or subsequent bit main data D (step I2) and an error correction process is executed on the basis of substitute data and the second error detection code F (step I3). Thus, steps I2 to I5 are repeatedly executed and an error detection process (step I2) is executed on the basis of a first error detection code E and bit pair F, R in each of the rows assuming the same location regarding an eighth (actually, upper bit) and subsequent bits, and an error correcting process is executed on the basis of the substitute data and second error detection code G (step I3).

When the eleventh byte error has been corrected (NO at step I4), the RW side control 82 clears the counter N for counting bytes to zero (step I6) and then executes an error detection process on the basis of the bit pair F, R for each one of addresses (step I7) and an error correction process on the basis of the substitute data and the first error detection code E (step I8). Upon end of 0-th byte process, the RW side control 82 increments the counter N to execute a correction process to a 7-th byte (YES at step I9), returning to step I7. The RW side control 82 executes an error detection process (step I7) on the basis of the bit pair F, R (step I7) and an error correction process (step I8) on the basis of the substitute data and the first error correction code E for each one of the addresses regarding 1st and subsequent byte main data D. Thus, the RW side control 82 repeatedly executes steps I7 to I10 and determines whether or not errors have been resolved in all the data (step I11), after end of the 7th bit error correction (NO at step I9). When the error has not been resolved, the RW side control 82 returns to step I1 (NO). When the error has been resolved (YES), the RW side control 82 writes the data with no error into the tag side memory 72C (returns to step B5 of FIG. 24), ending the process.

In the above-described successive error correction process (steps E1 to E10) and particularly step E, the RW side control 82 repeatedly executes the error correction process for each one of the rows assuming the same bit location at steps I1 to I5 and the error correction process for each one of addresses at steps I7 to I10. Accordingly, data error can be resolved more reliably. More specifically, for example, assume now that 3 or more bit burst error has occurred in a plurality of portions of addresses of main data D0, 0 to D7, 7 or rows assuming the same bit location. Even in this case, the errors are reliably detected on the basis of the bit pair, and the error correction process is repeatedly executed on the substitute data and the first and second error detection codes E, F and G for each one of the addresses or each one of the rows assuming the same bit location. As a result, when one part of the data is repaired, another part of the data is repaired on the basis of the initially repaired part of the data in a manner of chain reaction. Consequently, when correction avalanche occurs, all the errors can be corrected even when the tag side memory 72C is in a third stage where the aforesaid burst error or random error is occurring.

As described above, in the data management system 21, the redundant data includes encoded data of bit pair F, R indicative of "01" and "10" further indicative of the values of 0, 1 of each bit of the data respectively. When the values of both bits of the bit pair are 0 regarding the data read from the tag side memory 27C, the RW side control 82 determines that the bit pair contains an error. According to this, even in the case where data error is about to occur in which data stored in the memory cell of the tag side memory 72C is changed from "1" to "0" in one direction by the transmitting radiation, the RW side control 82 determines that the data represented by the bit pair F, R, when the values of the bit pair are 0. Consequently, the data management system 21 can be provided in which data error can be detected reliably and easily on the basis of the bit pair F, R, whereupon occurrence of data error can be prevented in the specific environment exposed to radiation.

Furthermore, even when the data error which changes the data in one direction is about to occur, the RW side control 82 executes the logical OR operation of both bits of the bit pair F, R. When the result of operation is 1, the RW side control 82 determines that no error is contained in the data. When the result of operation is 0, the RW side control 82 determines that error is contained in the data. More specifically, the bit pair F, R is generated as 01 or 10 and the logical OR operation of bits F and R indicates 0. Accordingly, the RW side control 82 can easily specify and reliably detect error of data stored in the tag memory 72C, whereupon the processing speed can be improved.

Moreover, since both bits F, R of the bit pair stored in the tag side memory 72C have different addresses and the same bit location, the processing speed can further be improved.

The redundant data contains at least any one of the first error detection code E generated with respect to each 1-byte data and the second error detection codes F, G generated with respect to each same bit location of the data. Accordingly, the RW side control 82 can detect error on the basis of the first and second error detection codes E and F as well as on the basis of the error detection on the basis of the bit pairs F, R. Consequently, error can reliably be detected and a correction probability by the error correction process can be improved.

When detecting an error based on the logical OR operation of both bits of the bit pair F, R, the RW side control 82 substitutes data 0, 1 (the substitute data) into the bit pair in which the error has been detected, thereby executing the error correction process on the basis of the error detection code. The error correction process is carried out until no error is detected. Accordingly, for example, when data error occurs in two bit pairs F, R (the number of pairs is designated by "x'; there are four patterns ($2^x$) of substitute data substituted into the two bit pairs F, R. Consequently, data error can reliably be repaired on the basis of the substitute data.

When detecting an error based on the logical OR operation of both bits of the bit pair F, R, the RW side control 82 executes the first error correction process in which the error correction process is carried out for each one of the addresses containing the detected errors on the basis of the substitute data and the first error detection code E, until no error is detected. The RW side control 82 also executes the second error correction process in which the error correction process is carried out for each one of the rows assuming the same bit location on the basis of the substitute data and the second error detection codes F, G, until no errors are detected. According to this, for example, when the first and second error correction processes are repeatedly executed, one part of the data can be repaired and another part of the data can also be repaired on the basis of the initially repaired data in a manner of chain reaction. Consequently, all the errors can be corrected even when the tag side memory 72C is in a third stage where the aforesaid burst error or random error is occurring.

When writing data into the tag side memory 72C, the RW side control 82 reads data of all the addresses other than the address to which the data is written and executes the error detection process and the error correction process on the basis of the redundant data (steps B1 to B4). According to this, every time data is written into the tag side memory 72C, data of all the addresses of the memory 72C can be generated without containing error. Furthermore, the memory cells can be recharged or refreshed by reading all the data even when there is no data error. The damage at the first stage can be repaired even when electrons in the floating gates are lost by the radiation delivery.

When having executed the error correction process, the RW side control 82 writes the corrected data into the non-volatile storage unit (step B5). Accordingly, the RW side control 82 can provide an opportunity to correct error regarding the data of all the addresses of the memory 72C every time writing the data into the tag side memory 72C.

The same data is written into a plurality of different areas of the tag side memory 72C, whereupon the data is multiplexed. The RW side control 82 executes a logical operation between the multiplexed data having the same bit according to a considered data error pattern. The RW side control 82 then executes an error detection process based on the redundant data regarding the bit row obtained by the operation. When no error is detected, the RW side control 82 determines that the bit row data is correct.

According to this, even in the case where data error occurs in one bit of 1-byte data, the error of the data at the bit location can reliably be corrected as the result of the logical OR operation between the bits of data error and the corresponding multiplexed data when correct data is present at the correcting bit of the other of the multiplexed data. Furthermore, the RW side control 82 can determine that no error is contained in data on the basis of the redundant data regarding the bit row, whereupon the reliability of the data management system 21 can be improved. Additionally, when the change from "0" to "1" in one direction occurs, a logical AND operation is carried out instead of the logical OR operation, whereupon an error can be repaired in the same manner as described above.

When executing the error detection process and the error correction process on the basis of the bit pair F, R and error detection codes E, F and G and determining that the corrected data still contains an error, the RW side control 82 executes the logical OR operation between the multiplexed plural data for corresponding bits. According to this, the correction probability can further be improved by a superimposed error correction process using a plurality of types of redundant data R, E, F, G, F' and R', in addition to the above-described effects.

The redundant data includes a parity code P added to each one of bits constituting data according to the combination of adjacent bits. The RW side control 82 corrects bit error on the basis of the bit data containing no error and the parity code P in the error correction process. According to this, since the parity code P is added according to the combination of adjacent bits, a correction process differing from the correction process based on the redundant data R, E, F, G, F' and R' can be executed, whereupon the correction probability can further be improved.

When reading data from the tag side memory 72C, the RW side control 82 repeatedly reads data until the same data is read consecutively at least twice with respect to the same address. For example, there is a possibility that data may be corrupted by radiation delivered to the antenna 75 of the RFID tag 70C. However, the data corruption can reliably be prevented during data read from the tag reader/writer 20A side by obtaining data repeatedly until the same data is read consecutively at least twice.

In the foregoing embodiment, the process from data read to data write is carried out when the data is written using the handy type tag reader/writer 20A (steps B1 to B5). However, data may be read from the tag side memory 72C at intervals of a predetermined period of time using the stationary type tag reader/writer 20B, instead. In this case, the predetermined time period is set according to radiation intensity as an amount of radiation and an irradiation period of radiation and is more specifically set to a time period shorter than a time period during which delivery of radiation results in data corruption in the tag side memory 72C under a radiation environment. Since an amount of radiation is inversely proportional to square of the distance from a radiation source, the control 82 of the tag reader/writer 20B may execute steps B1 to B5 based on instructions given by an upper device such as the personal computer 24 at intervals of a short period of time (several minutes, for example).

There is also a possibility that the data error which changes data in one direction may occur under a high temperature environment as well as under the radiation environment. Accordingly, the same effect as described above can be achieved when the steps B1 to B5 are executed while the aforesaid predetermined period time is suitably set in consideration of a temperature characteristic of the memory 72A causing data error.

In the active type RFID tag 70A, too, steps B1 to B5 may be executed at intervals of the above-described predetermined time or when there is no other preferential processing, with the control 71A serving as a subject relative to the memory 72A. More specifically, as described above, the memory 72A of the RFID tag 70A stores the control program such as stored in the memory 83 of the tag reader/writer 20, the error correction program and the like. The memory 72A also stores the redundant data such as stored in the tag side memory 72C. Accordingly, the control 71A reads data from the memory 72A and executes an error detection process for the read data on the basis of the redundant data. An error correction process can be carried out when an error has been detected in the error detection process.

In the active type RFID tag 70A, furthermore, when receiving write data from the tag reader/writer 20 via the wireless communication unit, the control 71A generates redundant data from the received data and writes the redundant data into the memory 72A together with the aforesaid data. When transmitting data via the wireless communication unit to the tag reader/writer 20, the control 71A may execute an error detection process and an error correction process on the basis of the redundant data affixed to the data to be transmitted, thereby transmitting data with no error. More specifically, since the active type RFID tag 70A can perform the same processing as the above-described tag reader/writer 20B, the RFID tag 70A can generate redundant data with respect to the data stored in the memory 72A thereof or can manage data by carrying out steps B1 to B5.

The RFID tags 70A to 70C are each configured as a slave to the handy type or stationary type tag reader/writer 20A, 20B (an external electronic device). Accordingly, the reliability of the RFID tags 70A to 70C can be improved under the above-described data management system 21.

Since the tag reader/writers 20A , 20B are configured as a master (an electronic device) of any one of the RFID tags 70A to 70C, the reliability of the data management system 21 can be improved using the tag reader/writers 20A, 20B.

<Eighth Embodiment>

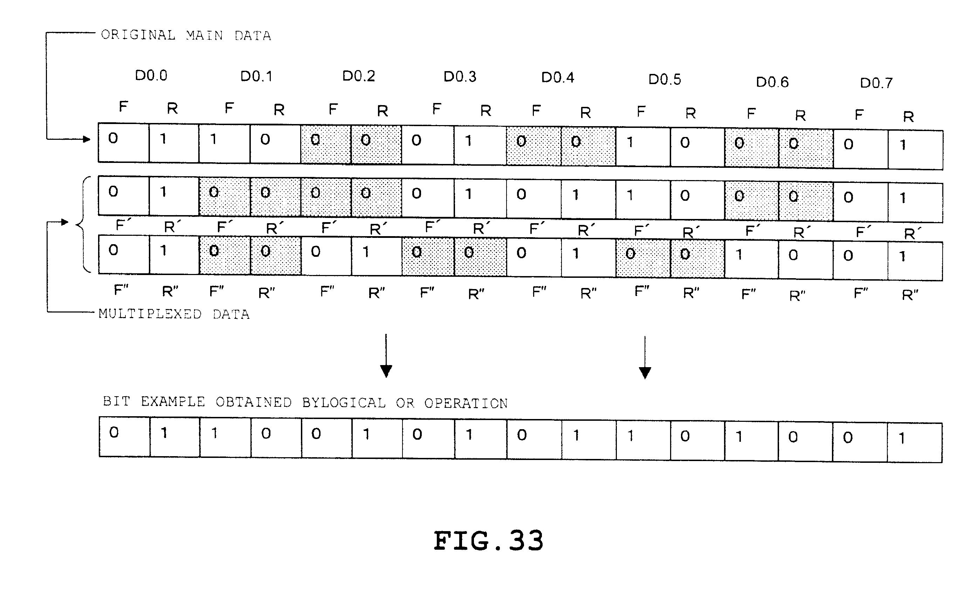

FIG. 33 illustrates an eighth embodiment and is similar to FIG. 32.

Data F", R" that is the same as the main data D0, 0-D7, 7 is written into a multiplexing data storage area 224 such that the main data D0, 0-D7, 7 is triplicated (see FIG. 33). Accordingly, in the logical OR operation (step G4 in FIG. 29) in the correction process relating to the multiplication, the logical OR operation is carried out for each one of corresponding bits between the original main data and the multiplexed main data D' and D". More specifically, as shown by shaded parts in FIG. 33, for example, three bit pairs F, R; F', R'; and F", R" by triplication in main data D0, 1; D0, 2; and D0, 6 include two bit pairs each having data error that the value becomes 00. Even in this case, when only one correct data assumes the same bit location, a bit row with data error having been repaired can be obtained as the result of the logical OR operation of the bits.

Differing from the embodiment, when an error correction is carried out for each one of bits on the basis of decision by majority regarding the three bit pairs F, R; F', R'; and F", R", there is a possibility that error would become the majority and a wrong correction may be carried out regarding the three-staged data error. On the other hand, when even only one correct data is present at the same bit location, data error in the other two bit pairs corresponding to the bit can completely be repaired in the case where error correction is carried out on the basis of the logical OR operation in the manner of the embodiment. Accordingly, the reliability of the data management system 21 can further be improved. Additionally, the multiplication should not be limited to duplication and triplication and quadrupled or higher multiplexed data may be contained as redundant data.

<Ninth Embodiment>

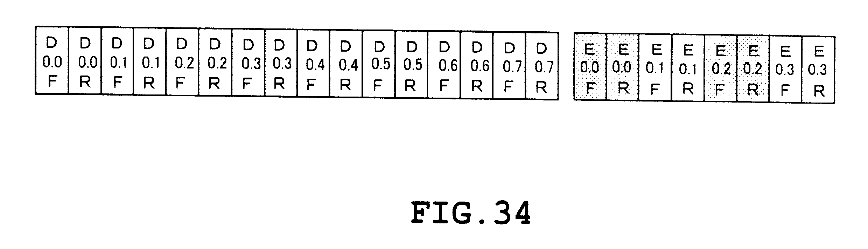

FIG. 34 illustrates a ninth embodiment and is similar to FIG. 21B.

As described above, the RW side control 82 carries out the logical OR operation of the bits F, R of the bit pair regarding the main data D read from the tag side memory 72C and bit pairs F, R of the first error detection code E (step B2). When determining at step S3 that the bit pair F, R contains error (YES), the RW side control 82 executes the following step, instead of the step S4.

More specifically, the RW side control 82 determines whether the bit pair F, R of the main data does not contain error or whether or not the bit pair F, R of the error detection code (the first error detection code E, for example) contains error. When the bit pair F, R of the main data D contains error, the RW side control 82 proceeds to step B4. On the other hand, when only the bit pair F, R of first error detection code E contains error (see FIG. 34), the RW side control 82 generates new first error detection code for each one of addresses on the basis of bit pair F, R of the main data D with no error. Consequently, the error of the bit pair F, R of the first error detection code E can be corrected, and corrected data is written into the tag side memory 72C (proceeding to step B5).

There can be a case where the bit pair F, R of the main data D has no error and only the bit pairs F, R of the first error detection codes E0, 0; and E0, 2 contain errors, as shown by shaded parts in FIG. 34. In this regard, as described above, since the first error detection code E has been encoded as bit pair F, R (error detection code bit pair), the error detection can reliably be carried out in the first error detection code E by execution of logical OR operation of the bit pair F, R, and the error correction process can reliably be carried out on the basis of the bit pair F, R of the main data D with no error. Additionally, the second error detection codes F, G may be encoded as bit pair F, R.

<Tenth Embodiment>

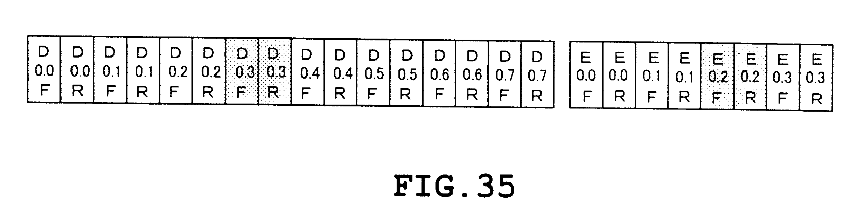

FIG. 35 illustrates a tenth embodiment and is similar to FIG. 34. In the error correction process in the seventh embodiment, for example, in the flowchart (steps F1 to F5) of FIG. 28, the example has been described in which the error is corrected on the basis of substitute data for 1-byte with the main data D as the object to be corrected. In this regard, as shown in FIG. 35, there can be a case where errors occur in the bit pair F, R of the main data D0, 3 and the bit pair F, R of the first error detection code E0, 2 respectively. Even in this case, when the number of errors of the bit pair F, R is not more than 2, the substitute data is sequentially substituted into the bit pairs F, R of the corresponding main data D0, 3 and first error detection code E0, 2, and the error detection process is carried out on the basis of the first error detection codes E0, 0F-E0, 3R. The error correction can be carried out until no error is detected. More specifically, a range (address and bit location) to be corrected can suitably be set according to an error pattern of data or the like in the error correction process.

<Eleventh Embodiment>

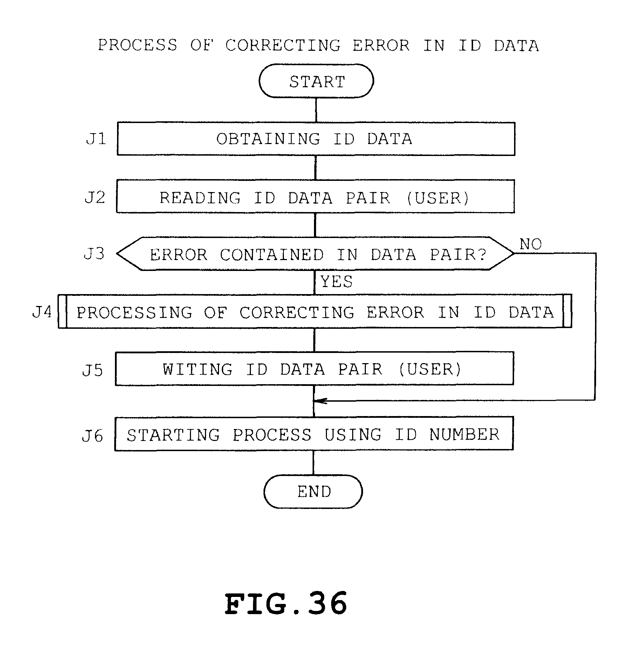

FIG. 36 illustrates an eleventh embodiment and is a flowchart of the process of obtaining the ID data from the RFID tag 70C by the use of the handy type tag reader/writer 20A.

The tag reader/writer 20A is configured to be simultaneously readable to identify a plurality of RFID tags 70C existing in a communication area. In the eleventh embodiment, the RFID tags 70C affixed to a plurality of articles 27c conveyed into and out of the above-described facility 27 are simultaneously read. Furthermore, ID data is stored in the TID storage area 200 (see FIG. 16) so as to be unrewritable, while redundant data of the ID data is stored at a dedicated area (a redundant area for ID data) in the redundant area 220. Each bit of the ID data indicates the values of 1 and 0, and one of the values of 1 and 0 is indicated as 01 and the other as 10. The redundant data includes the other bit R (inverted data DR indicated as [ID] DR. Furthermore, the redundant data includes a first error detection code (indicated as [ID] ER in FIG. 18) to correct error of the inverted data DR of the ID data, for example. In simultaneously reading the plural RFID tags 70C, the RW side control 82 reads ID data from the TID storage area 200 of the tag side memory 72c of each RFID tag 70C (step J1). In the following description, only one RFID tag 70C will be described but actually, steps J1 to J6 are carried out for the plural RFID tags 70C.

The RW side control 82 reads the inverted data DR of the ID data and the first error detection code ER from the redundant area of the tag side memory 72C after step J1 (step J2) to execute the logical OR operation of the bits corresponding to each other between the ID data and the inverted data. When neither bit is 1 (YES at step J3), the RW side control 82 executes the correction process relating to the inverted data DR (step J4). In this case, 0 or 1 (substitute data) is substituted into the bit R determined to be error. The RW side control 82 executes the error detection process on the basis of the first error detection code ER regarding the inverted data DR into which the substitute data has been instituted. When the error correction process is carried out on the basis of the substitute data and the first error detection signal ER until no error is detected, correct inverted data DR can be obtained regarding the error up to 2 bits. The inverted data DR to which the error correction process has been applied is written into the tag side memory 72C (step J5), and the data obtained by inverting the inverted data DR is used as the original ID data in the tag reader/writer 20A, so that various processes are initiated on the basis of the ID data (step J6).

The error to be detected at step J3 includes an error in ID data read from the TID storage area 200 and an error in the inverted data DR side read from the redundant data storage area. In the case of the former error, a correction process relating to the inverted data is carried out at step J4 since the user cannot rewrite the TID storage area. Subsequently, the data obtained by further inverting the inverted data DR is used as the ID data but not the ID data read from the TID storage area 200 irrespective of which data contains an error.

As described above, the RW side control 82 executes the error detection process on the basis of the redundant data DR and ER regarding the ID data read from the tag side memory 72C. Accordingly, the eleventh embodiment can achieve the same effect as the seventh embodiment, regarding the ID data. Furthermore, since the ID data is associated with other data in the RFID tag 70C (identification information such as product code, for example), the ID data after execution of error correction process and the other data can be caused to correspond to each other by execution of an error correction process on the basis of redundant data DR and ER, whereupon various processes can be executed without any difficulty. Additionally, the redundant data of the ID data should be limited to bit pair R and the first error detection code ER. The error detection process and the error correction process can be carried out on the basis of the above-described various redundant data.

Furthermore, since the error detection process and the error correction can be carried out on the basis of various redundant data in the following twelfth embodiment in the same manner as in the eleventh embodiment, the reference symbol of the redundant data will be eliminated regarding the error detection process and the error correction process and detailed description thereof will be eliminated.

<Twelfth Embodiment>

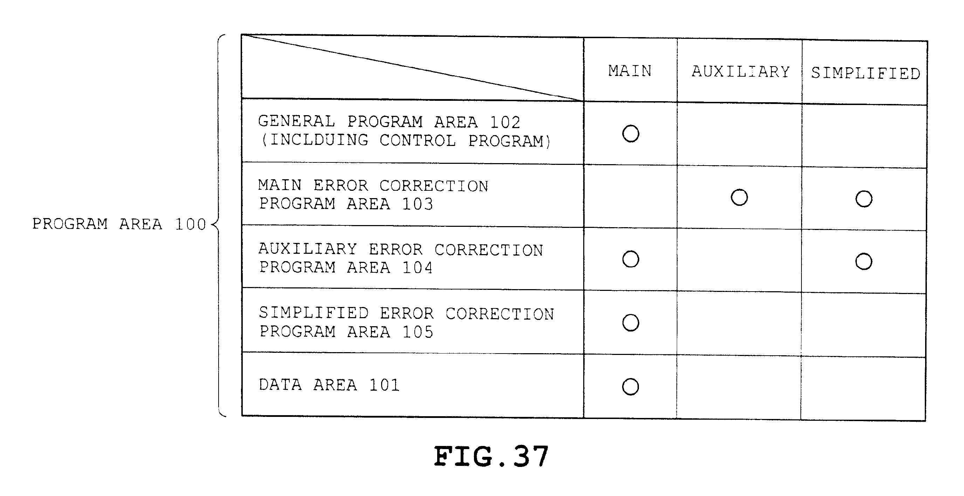

FIGS. 37 to 39 illustrate a twelfth embodiment. FIG. 37 shows three types of error correction programs, that is, a main error correction program, an auxiliary error correction program and a simplified error correction program, shown in the map image of the memory 72A of the RFID tag 70A as shown in FIG. 15A. FIG. 37 further shows objects with respective errors to be corrected. The objects whose errors are to be corrected by the main error correction program are the data area 101, the general program area 102 except for itself, the auxiliary error correction program area 104 and the simplified error correction program area 105. The object whose errors to be corrected by the simplified error correction program is only the main error correction program area 103.

The main and auxiliary error correction programs have the same contents. In the initial setting at the time of start-up, either one of the programs is instructed to operate as the main program and the other is instructed to operate as the auxiliary program, whereby areas (address range) to which error correction is applied are determined. The main and auxiliary error correction programs are adapted to execute similar processes regarding to programs of the program areas 102 to 105 to the error detection and error correction carried out regarding data of the data area 101 in each of the foregoing embodiments.

Furthermore, the object regarding which the simplified error correction program executes an error correction includes the main error correction program 103 and the auxiliary error correction program 104. The simplified error correction program starts up when an error has been detected in itself in execution as the result of execution of main or auxiliary error correction program. The simplified error correction program is repaired by copying to an address at which the error has been detected, the contents of the corresponding address in the correction program containing no error. Each program is configured to operate on a multitask OS (operating), for example. An execution state of each program can be switched when the multitask OS caries out task switching.

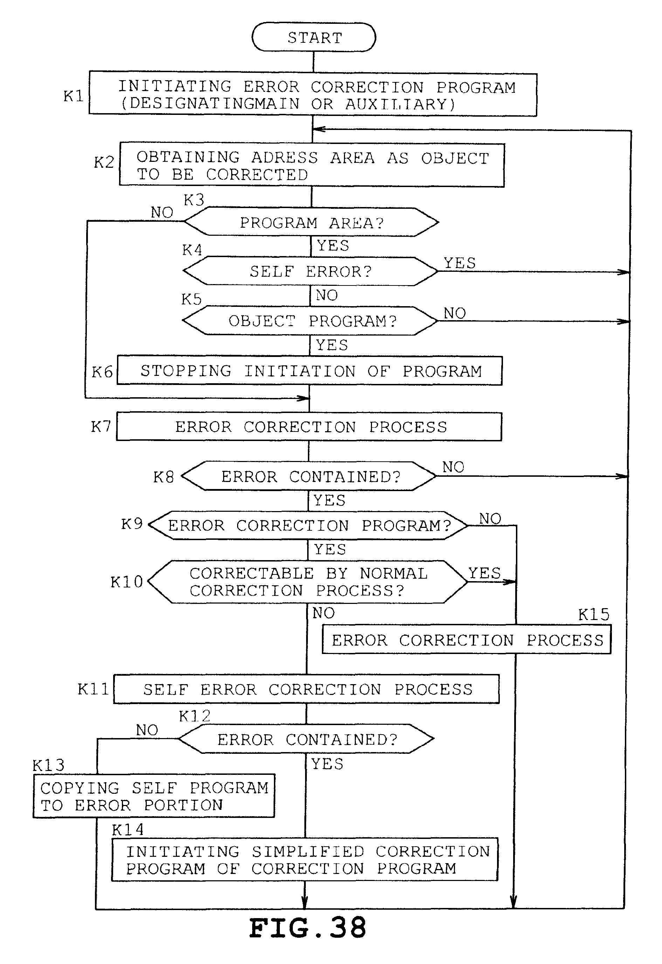

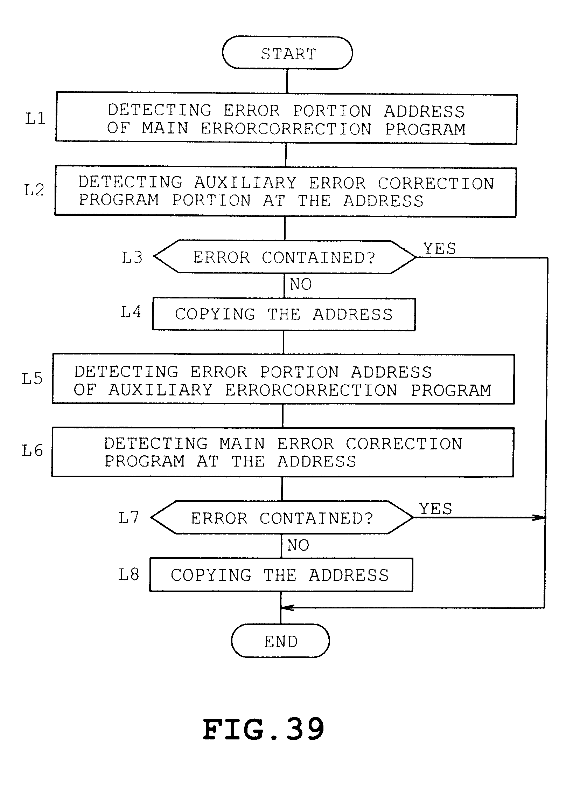

The operation of the twelfth embodiment will now be described with reference to FIGS. 38 and 39. FIG. 38 is a flowchart showing processing contents of the main or auxiliary error correction program. When main or auxiliary error correction program is designated by task switching thereby to start up (step K1), an address area to be corrected is obtained (step K2). In this case, the program areas 102 to 105 or data area 101 to be corrected and areas of corresponding redundant data are read collectively. When the data area 101 is to be corrected (NO at step K3), an error detection process is executed (step K7). When no error has been detected (NO at step K8), the RW side control 82 returns to step K2.

On the other hand, at step K3, when the object to be corrected is any one of program areas 101 to 105 (YES) and is not a program area of itself (NO at step K4), the RW side control 82 determines whether or not the program needs to be stopped for correction (step K5). More specifically, when the main error correction program is in operation, the RW side control 82 determines whether or not the general program or auxiliary program needs to be stopped. When the auxiliary error correction program is in operation, the RW side control 82 determines whether or not the main error correction program needs to be stopped. When these programs need to be stopped (YES), the start-up of these programs is stopped (step K6). Additionally, processing at steps K5 and K6 is necessary when there is a possibility that a plurality of programs is executed in parallel to each other in the arrangement of the multiple CPU. Processing at steps K5 and K6 is unnecessary when task switching is carried out in the single CPU.

When the error has been detected as the result of execution of step K7 (YES at step K7), the RW side control 82 determines whether or not the object to be corrected is the main or auxiliary error detection program (step K9). When the object is the data area 101 (NO), the RW side control 82 executes an error correction process based on the redundant data (step K15). On the other hand, when the object is the main or auxiliary error correction program (YES), the RW side control 82 determines whether or not a normal error correction process is executable (step K10). When the normal error correction process is executable (YES), the RW side control 82 proceeds to step K15. The redundant data prepared for each program is a bit pair, a parity code, multiplexing data, an error detection code and the like as in the data in the data area 101, and the error detection and error correction are executed in the same manner as the data in the data area 101.

When the normal correction process of the main or auxiliary correction program is impossible (NO), the RW side control 82 executes the error detection process regarding the program thereof based on the redundant data (step K11). When no error has been detected (NO at step K12), the RW side control 82 writes, into the error detection address of the object program detected at step K8, the contents of the corresponding address in the program thereof (step K13). On the other hand, when an error has been detected (YES), the RW side control 82 starts up the simplified error correction program (step K14).

FIG. 39 is a flowchart showing the processing contents of the simplified error correction program. Firstly, when having detected an address in which an error has occurred regarding the main error correction program (step L1), the RW side control 82 detects the contents of an address of the auxiliary error correction program corresponding to the aforementioned address (step L2). In the address detection at step L1, for example, when an error has been detected at step K12, the address of the main or auxiliary error correction program may be written into a predetermined area thereby to be stored, and the simplified error correction program may read the address stored in the predetermined area. Furthermore, the simplified error correction program may re-execute error detection regarding the main error correction program based on the redundant data.

When the contents of the corresponding address of the auxiliary error correction program contain no error at step L3 (NO), the RW side control 82 copies the contents of the address to the erroneous address of the main error correction program, thereby repairing the main error correction program (step L4). In the subsequent steps L5 to L8, the auxiliary error correction program is repaired by the contents of the corresponding address of the main error correction program when an error has been detected in the auxiliary error correction program at step K12. When the auxiliary and main error correction programs contain errors at steps L3 and L7 respectively (YESES), the RW side control 82 ends the processing since the counterpart program cannot be repaired.

When the RFID tag 70A is placed under an environment of exposure to radiation, cosmic rays or the like or a high temperature environment, an error occurs in programs placed in the program areas 102 to 105 of the memory 72A with an equal probability to the data placed in the data area 101. In view of this, the main, auxiliary and simplified error correction programs are operated in the twelfth embodiment as described above, so that an error in the general program is corrected and repaired. More specifically, when an error occurs in each of the general, the auxiliary and simplified error correction programs, the error is corrected by the main error correction program. When an error occurs in the main error correction program, the error is corrected by the auxiliary error correction program.

Furthermore, when an error that cannot be corrected by the redundant data occurs in one of the main and auxiliary error correction programs and an error also occurs in the other program, the simplified error correction program starts up. When the errors can be corrected by part of the other program in which part no error has occurred, the part is copied to one side for repair. The main and auxiliary error correction programs have the same contents, and errors simultaneously occur in addresses of both programs corresponding to the same program step with an extremely low probability. Accordingly, error correction can triply be carried out by these operations.

An object code executed as a program is at one side of bit pair F, R, more specifically, at the side of the same value as the original program in which 0 is represented as 01 and 1 as 10.

According to the twelfth embodiment described above, the main, auxiliary and simplified error correction programs are placed in the memory 72A of the RFID tag 70A together with the general program, and the redundant data for executing error correction regarding each of the programs is placed in the data area 101. The main error correction program corrects an error occurring in the general, auxiliary and simplified error correction programs. The auxiliary error correction program corrects an error occurring in the main error correction program. When an error that cannot be corrected by the redundant data occurs in one of the main and auxiliary error correction programs and an error also occurs in the other program, non-erroneous part of one of the main and auxiliary error correction programs is copied to the other program for repair. Accordingly, even when the RFID tag 70A is placed under an environment of exposure to radiation, cosmic rays or the like or a high temperature environment, an error occurring in the general program can be corrected with an exceedingly high probability.

Regarding the above-described error detection and error correction processes, the main, auxiliary and simplified error correction programs are also placed in program areas 303 to 305 of the memory 83 of the tag reader/writer 20A as shown in FIG. 15B. Accordingly, the same processes as described above are executed regarding the program areas 302 to 305 and data area 301.

<Thirteenth Embodiment>

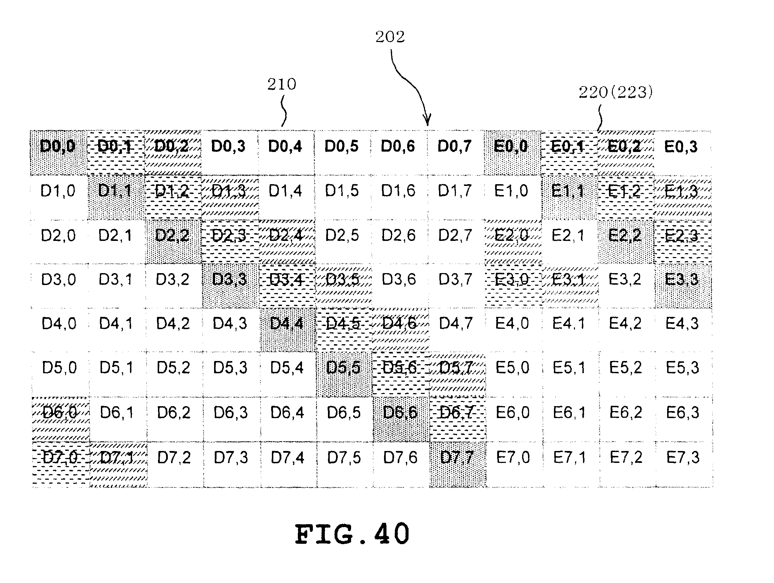

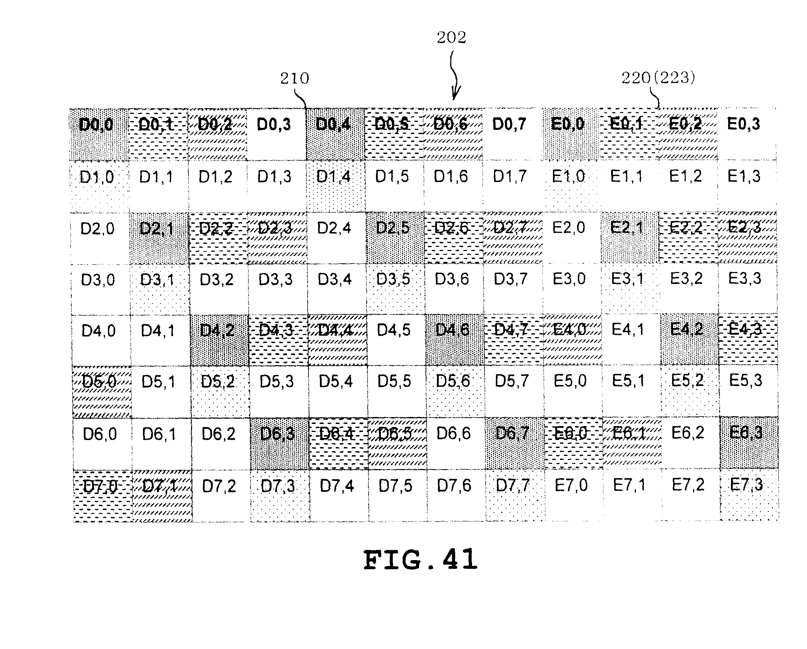

FIGS. 40 and 41 illustrate a thirteenth embodiment. FIG. 40 is similar to FIG. 17A and shows the main data area 210 and a third redundant data area 223 provided instead of the first error detection code (first redundant data). A case will be described where a third error correction code data differing from the first error detection code E and the second error detection codes F and G is used. Bit patterns in respective FIGS. 40 and 41 show bits having the same pattern belong to the same bit row.

For example, in FIG. 40, the bit location is shifted by 1 bit every time of increase by one address, whereby a bit row is constituted by combining 8 bits. A 4-bit error detection code is added to the 8-bit data (a third error detection code). For example, data D0, 0; D1, 1; and D2, 2 to D7, 7 belong to the same bit row. Redundant data E0, 0; E1, 1; E2, 2; and E3, 3 are generated in an arrangement that the bit location is shifted by 1 bit relative to the aforesaid bit row every time of increase by one address. Furthermore, regarding the bit row beginning from second bit data D0, 1, an end bit is first bit data D, 0. Regarding the bit row beginning from third bit data D0, 2, a seventh bit is data D6, 0 and an end bit is second bit data D7, 1.

In FIG. 41, the bit location is shifted by 1 bit every time of increase by two addresses, whereby a bit row is constituted by combining 8 bits. For example, data D0, 0; D2, 1; D6, 3; D0, 4; D2, 5; D4, 6; and D6, 7 belong to the same bit row. Redundant data E0, 0; E2, 1; E4, 2; and E6, 3 are generated in an arrangement that the bit location is shifted by 1 bit relative to the aforesaid bit row every time of increase by two addresses. More specifically, although the bit location is shifted by 1 bit every time of increase in the address, a range of increase is limited by the data bit number of 1 word, whereupon the increase range does not exceed +7 from the address at which an initial bit is obtained. An excess from +7 is returned to an address obtained by subtracting 8.

The pattern composing the bit row to affix the third error detection code should not be limited to those as shown in FIGS. 40 and 41. For example, the bit location may be shifted by 2 or 3 bits every time of increase by one address.

Furthermore, the third redundant data area 223 is replaced by the first redundant data area 221 as shown in FIG. 17A for the convenience of explanation. Actually, however, since these are different data areas and independent of each other, the third error detection code can be used with the first and second error detection codes for error detection. The third redundant data area 223 may or may not be arranged in the same manner as the corresponding bit row. For example, the third redundant data area 223 may be arranged in the same manner as the first error detection code.

According to the thirteenth embodiment described above, the third error detection code is affixed to the bit row formed by shifting the bit location by 1 bit or more. As a result, even when a burst error in which errors are consecutive in the ordinary data arrangement has occurred in data area 201, the number of erroneous bits can be reduced regarding the aforesaid bit row. Accordingly, when the error detection and the error correction are carried out on the basis of the third error detection code, the possibility that a larger number of errors can be corrected can be improved.

The invention should not be limited to the embodiments described above with reference to the accompanying drawings. The above-described data management method can be applied to various types of memory devices provided with a nonvolatile storage unit from and into which the control reads and writes data.

The tag reader/writer 20 is configured to execute the error detection process and the error correction process regarding the data read from the tag side memory 72C. However, the tag reader/writer 20 may be configured to execute the error detection process and the error correction process regarding data relating to its own memory 83. More specifically, since it can be considered that the tag reader/writer 20 can be used under an environment in which data error frequently occurs in the memory 83 serving as the device side storage unit, redundant data for correcting error in data is stored together with the data. When the error detection and error correction processes are executed using the bit pair serving as the redundant data in the same manner as described above, the tag reader/writer 20 can be prevented from occurrence of data error and can normally function.

Furthermore, the main and auxiliary error correction programs and the redundant data to correct an error in these error correction programs are configured as data to cause the tag reader/writer 20 to function normally. Consequently, the reliability of the tag reader/writer 20 can also be improved in the same manner as the RFID tag 70C.

When power is supplied to the handy type tag reader/writer 20A, the control 82 is configured to execute the error detection process on the basis of redundant data regarding at least the control program executed by the control 82, out of the data read from the memory 83. According to this, even when data error is occurring in the memory 83, the error of the program is preferentially detected and corrected before execution of the control program, whereupon the tag reader/writer can normally start up.

Furthermore, when power is supplied to the active type tag reader/writer 70A, the control 71A is configured to execute the error detection process on the basis of the redundant data regarding at least the control program executed by the control 82, out of the data read from the memory 72A. According to this, the error of the program is preferentially detected and corrected in the RFID tag 70A before execution of the control program, whereupon the tag reader/writer can normally start up.

For example, an RFID tag 70C may be provided other than the original RFID tag 70C. One F of bit pair F, R is written into the tag side memory 72C of one of the RFID tag 70C and the other bit R is written into the tag side memory 72C of the other RFID tag 70C. The RW side control 82 reads data from both tag side memories 72C to execute the error detection process based on the bit pair F, R. According to this, the original data is stored in one of the tag side memory 72C, and the inverted data obtained by inverting the original data is stored in the other tag side memory 72C. Consequently, the same effect as the seventh embodiment can be achieved with the use of the paired RFID tags 70C.

The RFID tag 70A side or the tag reader/writer 20A, 20B executes, as a subject, the above-described various processes according to the combination of the types 70A to 70C of the RFID tag 70 and the types 20A and 20B of the tag reader/writer 20. Consequently, the data management method can be provided in which reliability of both RFID tag 70 and tag reader/writer 20 can be improved.

An extended Golay code may be used for execution of the error detection process instead of the hamming code. More specifically, the extended Golay code is formed so as to substitute a 24-bit code word with 12 as the error correction bit number for 12-bit main data. In this case, a 7-bit error detection function or a 4-bit error detection function and 3-bit error correction function may suitably be set. Accordingly, although the extended Golay code requires more storage areas than the hamming code, the error detection and correction functions can be improved.

The above-described steps D1 to D3 may be eliminated in the read process. In the first to ninth embodiments, the structure of the laminate may be changed according to a radiation level applied to the RFID tags of the respective embodiments, or the like. In this case, the shielding member may be foil-shaped, plate-shaped or block-shaped. The laminate 2 may not be divided into the first and second laminate portions 5 and 6. The laminate 2 may have the lamination structure and be formed into a bag-like housing which houses an entire RFID circuit 4. The housing may be made of a soft material, such as the aforesaid thermoplastic resin, that does not block the effect of shielding from radiation or a material having the characteristic as a dielectric substance, whereupon the existing RFID tag can be applied to housing. Furthermore, in the layered structure of the laminate 2, the housing and the like, the RFID tag may be configured into a metal applicable tag by interpose of a soft magnetic layer. More specifically, when the RFID tag is directly provided on a metal article, there is a possibility that the communication distance may be reduced or non-operative. However, for example, when a spacer layer is formed for the soft magnetic material layer or the metal article, a sufficient communication distance can be ensured.

In view of a case where gamma rays are instantaneously discharged during absorption of neutron into the shielding member, the gamma-ray shielding member may also be disposed outside the neutron-ray shielding member as well as inside the neutron-ray shielding member. Thus, the layered structure, the number of lamination, dimensions and the like may be changed. Furthermore, the RFID tag can be configured into an active type or a passive type relative to the laminate having various lamination structures. Thus, the RFID tag should not be limited to the combination of the laminate 2 and the active type and the passive type. The holes 31 and 36 in the second and third embodiments may be changed in the shapes, locations, sizes and the like according to the type of the sensor 12 and the like so that the radiation shielding function of the shielding members 7 and 8 are prevented from being damaged.

Furthermore, in the RFID tag affixed directly or indirectly to the heating element in the second and third embodiments, a thermoelectric couple may be employed as the power supply, instead of the cell 13. More specifically, the RFID tag is provided with an electric power converter circuit which converts electromotive force generated by the thermoelectric couple to an electric power to be supplied to the RFID tag. One of connecting points of the thermoelectric couple is placed at the power feed side, and the other connecting point is placed on an external heating element (the piping 27a in FIG. 8B, for example). When the RFID tag is placed on an outer periphery of the heat insulator 27b, power supply is possible using the temperature difference between the heating element and the RFID tag (Seebeck effect of thermoelecric couple).

Any one of the laminates in the first to ninth embodiments can be applied to any one of the RFID tags 70A to 70C. Any one of the laminates in the first to ninth embodiments can also be applied to either one of the tag reader/writers 20A and 20B. More specifically, the shielding members 7 and 8 of the first laminate portion 5 are applied to the substrate 81 of the tag reader/writer 20 so as to cover the reader/writer circuit 86, for example. In this case, antenna 20a is provided so as to be communicable with the outside without being covered by the first laminate portion 5. More specifically, when the reader/writer circuit 86 is disposed in the laminate so as to be covered by the shielding member in the same manner as the RFID circuits of the first to ninth embodiments, a high effect of shielding from radiation can be achieved.

Some embodiments of the invention can be applied to electronic devices and general storage devices each of which is provided with a control circuit such as the RFID circuit 4 or the reader/writer circuit 86 and the antenna electrically connected to the control circuit. More specifically, the control circuit is placed in the laminate so as to be covered by the shielding member in the electronic device or the storage device. The electronic device or the storage device is provided with a nonvolatile storage unit incorporated in the control circuit and storing data and a program and the redundant data for correcting the data and the program and a control for controlling data read and write from and into the nonvolatile storage unit. Accordingly, the electronic device and the storage device should not be limited to the RFID tag and the tag reader/writer both having a relationship of master and slave but may be provided with a high shielding function of the laminate against radiation and an error correcting function on the basis of the redundant data in personal computers or other communication equipment, whereupon occurrence of data error can be suppressed as much as possible. Additionally, when the electronic device or the storage device is provided with either the shielding effect by the laminate or the error correcting function, occurrence of data error can be suppressed under a radiation environment.

The laminate may include a proton shielding member for shielding from proton. In this case, the proton shielding member may be made of a material such as tungsten and is configured so as to have a layered structure together with the shielding member. The proton shielding member can shield from cosmic rays, proton captured by the Val Allen belt. Accordingly, when applied to various electronic devices and storage devices in the aerospace industry, a high effect of shielding from the cosmic rays can be achieved.

## Claims

1. An RFID tag which includes:

   a laminate (2) having a laminated structure;
   an antenna (3, 3', 75) provided on the laminate (2) so as to be capable of communicating with outside; and
   an RFID circuit (4, 4', 41, 76) electrically connected to the antenna (3, 3', 75), wherein:

   the laminate (2) has a shielding member (7, 7', 8, 8') which shields radiation; and
   the RFID circuit (4, 4', 41, 76) is disposed in the laminate so as to be covered by the shielding member (7, 7', 8, 8').

2. The RFID tag according to claim 1, wherein the laminate (2) has as the shielding member (7, 7', 8, 8') a gamma ray shielding member (7, 7') which shields from a gamma ray and a neutron ray shielding member (8, 8') which shields from a neutron ray.

3. The RFID tag according to claim 1 or 2, wherein the shielding member (7, 7', 8, 8') has a thickness that is set by a material thereof according to an amount of radiation.

4. The RFID tag according to any one of claims 1 to 3, wherein the laminate (2) has a first lamination having an upper side and a lower side both sandwiching the RFID circuit and vertically laminated and a second lamination which surrounds a side of the RFID circuit and laminated in a direction differing from a direction in which the first lamination is laminated.

5. The RFID tag according to any one of claims 1 to 4, wherein a plurality of the shielding members (7, 7', 8, 8') is formed into a sheet shape and configured integrally with each other by connecting units connecting the sheet-shaped shielding members.

6. The RFID tag according to any one of claims 1 to 5, wherein the laminate (2) is configured as a multilayer substrate made by stacking a plurality of the shielding members (7, 7', 8, 8');
   the RFID circuit being accommodated in the multilayer substrate; and
   wherein the number of times of lamination of each shielding member of the multilayer substrate is set by material thereof according to an amount of radiation.

7. The RFID tag according to claim 6, wherein each shielding member has layers each of which is made of a material according to radiation energy.

8. The RFID tag according to claim 6 or 7, which is of an active type that a power supply is incorporated in the multilayer substrate.

9. The RFID tag according to claim 8, further comprising a detecting unit (12) which detects an external environment of the multilayer substrate.

10. The RFID tag according to claim 9, wherein:

    the detecting unit (12) comprises a sensor using a radiation sensor or an optical unit and is disposed in the multilayer substrate; and
    the multilayer substrate is provided with a hole (31) which is located at a position separated from the RFID circuit (4, 4', 41, 76) on the multilayer substrate and through which the detecting unit (12) is exposed.

11. The RFID tag according to claim 9, wherein:

    the detecting unit includes a heat conduction portion having a higher heat conductivity than the shielding member (7, 7', 8, 8') and a temperature sensor disposed in the multilayer substrate so as to be brought into contact with the heat conduction portion and so as to detect a temperature of the heat conduction portion; and
    the heat conduction portion is exposed from the multilayer substrate or extend outward from the temperature sensor.

12. The RFID tag according to any one of claims 1 to 7, which is of a passive type that the RFID tag is operated with radio waves received from outside by the antenna (3, 3') serving as an energy source.

13. The RFID tag according to any one of claims 1 to 7, further comprising an inlet (43) having the antenna (3, 3') and the RFID circuit (4, 4', 41, 76) on the substrate, wherein the laminate (2) is disposed on the substrate so as to cover at least one side of the RFID circuit (4, 4', 41, 76).

14. The RFID tag according to any one of claims 2 to 13, wherein the gamma ray shielding member (7, 7')
is made of at least one of lead, a lead compound,
tungsten and a tungsten compound.

15. The RFID tag according to any one of claims 2 to
14, wherein the neutron shielding member (8, 8') is
made of at least one of boron, a boron compound,
gadolinium, a gadolinium compound, cadmium and
a cadmium compound.

**FIG.1A**

**FIG.1B**

# FIG.2

EP 2 790 132 A2

18a

| EXTERNAL DECTION UNIT CONNECTION |

12

| SENSOR |

13

| CELL |

18

| EXTERNAL I/F |

| MEMORY |

4

| CONTROL |

| COMMUNICATION |

15(72A)　16(71A)　17

1(70A)

3

| ANTENNA |

20a

| ANTENNA |

20(20A, 20B)

| R/W |

23a　23

| PC |

| SERVER |

24　25

21

**FIG.3**

FIG.4

EP 2 790 132 A2

EP 2 790 132 A2

FIG.5

FIG.6

REACTION
SECTIONAL AREA σ

8C

8D

8E

NEUTRON ENERGY Ev

# FIG.7

FIG.8A

FIG.8B

# FIG.9

# FIG.10

**FIG.11A**

**FIG.11B**

# FIG.12A

# FIG.12B

| | RFID TAG 70 | TAG READER/WRITER 20 |
|---|---|---|
| 1 | ACTIVE TYPE RFIID TAG 70A WITH CELL | STATIONARY RW 20B |
| 2 | PASSIVE TYPE RFID TAG 70B WITH CELL | STATIONARY RW 20B, HANDY TYPE 20A |
| 3 | PASSIVE TYPE RFID TAG 70C WITHOUT CELL | STATIONARY RW 20B, HANDY TYPE 20A |

FIG.13

**FIG.14**

EP 2 790 132 A2

NONVOLATILE STORAGE UNIT                    72A

| | |
|---|---|
| 102 | GENERAL PROGRAM AREA<br>(INCLDUING CONTROL PROGRAM) |
| 103 | MAIN ERROR CORRECTION<br>PROGRAM AREA |
| 104 | AUXILIARY ERROR CORRECTION<br>PROGRAM AREA |
| 105 | SIMPLIFIED ERROR CORRECTION<br>PROGRAM AREA |
| 101 | DATA AREA<br>(INCLUDING REDUNDANT DATA) |

PROGRAM AREA

## FIG.15A

MASTER SIDE STORAGE UNIT                    83

| | |
|---|---|
| 302 | GENERAL PROGRAM AREA<br>(INCLDUING CONTROL PROGRAM) |
| 303 | MAIN ERROR CORRECTION<br>PROGRAM AREA |
| 304 | AUXILIARY ERROR CORRECTION<br>PROGRAM AREA |
| 305 | SIMPLIFIED ERROR CORRECTION<br>PROGRAM AREA |
| 301 | DATA AREA<br>(INCLUDING REDUNDANT DATA) |

PROGRAM AREA

## FIG.15B

NONVOLATILE STORAGE UNIT

| | 72C |
|---|---|
| TID AREA | 200 |
| EPC AREA | 201 |
| DATA AREA (INCLUDING REDUNDANT AREA) | 202 |

# FIG.16

210   202   220(221)

## FIG.17A

| D0,0 | D0,1 | D0,2 | D0,3 | D0,4 | D0,5 | D0,6 | D0,7 | E0,0 | E0,1 | E0,2 | E0,3 |
|------|------|------|------|------|------|------|------|------|------|------|------|
| D1,0 | D1,1 | D1,2 | D1,3 | D1,4 | D1,5 | D1,6 | D1,7 | E1,0 | E1,1 | E1,2 | E1,3 |
| D2,0 | D2,1 | D2,2 | D2,3 | D2,4 | D2,5 | D2,6 | D2,7 | E2,0 | E2,1 | E2,2 | E2,3 |
| D3,0 | D3,1 | D3,2 | D3,3 | D3,4 | D3,5 | D3,6 | D3,7 | E3,0 | E3,1 | E3,2 | E3,3 |
| D4,0 | D4,1 | D4,2 | D4,3 | D4,4 | D4,5 | D4,6 | D4,7 | E4,0 | E4,1 | E4,2 | E4,3 |
| D5,0 | D5,1 | D5,2 | D5,3 | D5,4 | D5,5 | D5,6 | D5,7 | E5,0 | E5,1 | E5,2 | E5,3 |
| D6,0 | D6,1 | D6,2 | D6,3 | D6,4 | D6,5 | D6,6 | D6,7 | E6,0 | E6,1 | E6,2 | E6,3 |
| D7,0 | D7,1 | D7,2 | D7,3 | D7,4 | D7,5 | D7,6 | D7,7 | E7,0 | E7,1 | E7,2 | E7,3 |

## FIG.17B

| F0,0 | F0,1 | F0,2 | F0,3 | F0,4 | F0,5 | F0,6 | F0,7 | G0,0 | G0,1 | G0,2 | G0,3 |
|------|------|------|------|------|------|------|------|------|------|------|------|
| F1,0 | F1,1 | F1,2 | F1,3 | F1,4 | F1,5 | F1,6 | F1,7 | G1,0 | G1,1 | G1,2 | G1,3 |
| F2,0 | F2,1 | F2,2 | F2,3 | F2,4 | F2,5 | F2,6 | F2,7 | G2,0 | G2,1 | G2,2 | G2,3 |
| F3,0 | F3,1 | F3,2 | F3,3 | F3,4 | F3,5 | F3,6 | F3,7 | G3,0 | G3,1 | G3,2 | G3,3 |

220(222)

EP 2 790 132 A2

| | | |
|---|---|---|
| 0 | D0.0F ~ D0.7F | |
| 1 | D1.0F ~ D1.7F | |
| ⋮ | ⋮ | 210 |
| 100 | D0.0R ~ D0.7R | |
| 101 | D1.0R ~ D1.7R | |
| ⋮ | ⋮ | |
| | [ID]DR | |
| 200 | E0.0F ~ E0.3F | E1.0F ~ E1.3F |
| ⋮ | ⋮ | 220 |
| 280 | E0.0R ~ E0.3R | E1.0R ~ E1.3R |
| ⋮ | ⋮ | |
| | [ID]ER | |
| | D0.0F´ ~D0.7F´ | |
| | D1.0F´ ~D1.7F´ | |
| | ⋮ | 224 |
| | E0.0F´ ~E0.3F´ | E1.0F´ ~E1.3F´ |

FIG.18

EP 2 790 132 A2

| D 0.0 | D 0.1 | D 0.2 | D 0.3 | D 0.4 | D 0.5 | D 0.6 | D 0.7 | E 0.0 | E 0.1 | E 0.2 | E 0.3 |
|---|---|---|---|---|---|---|---|---|---|---|---|

ADDRESS 0      ADDRESS 200
(UPPER 4 BITS)

| D 1.0 | D 1.1 | D 1.2 | D 1.3 | D 1.4 | D 1.5 | D 1.6 | D 1.7 | E 1.0 | E 1.1 | E 1.2 | E 1.3 |
|---|---|---|---|---|---|---|---|---|---|---|---|

ADDRESS 1      ADDRESS 280
(LOWER 4 BITS)

**FIG.19A**

| D 0.0 F | D 0.1 F | D 0.2 F | D 0.3 F | D 0.4 F | D 0.5 F | D 0.6 F | D 0.7 F | E 0.0 F | E 0.1 F | E 0.2 F | E 0.3 F |
|---|---|---|---|---|---|---|---|---|---|---|---|

ADDRESS 0      ADDRESS 200
(UPPER 4 BITS)

| D 1.0 F | D 1.1 F | D 1.2 F | D 1.3 F | D 1.4 F | D 1.5 F | D 1.6 F | D 1.7 F | E 1.0 F | E 1.1 F | E 1.2 F | E 1.3 F |
|---|---|---|---|---|---|---|---|---|---|---|---|

ADDRESS 1      ADDRESS 200
(LOWER 4 BITS)

| D 0.0 R | D 0.1 R | D 0.2 R | D 0.3 R | D 0.4 R | D 0.5 R | D 0.6 R | D 0.7 R | E 0.0 R | E 0.1 R | E 0.2 R | E 0.3 R |
|---|---|---|---|---|---|---|---|---|---|---|---|

ADDRESS 100      ADDRESS 280
(UPPER 4 BITS)

| D 1.0 R | D 1.1 R | D 1.2 R | D 1.3 R | D 1.4 R | D 1.5 R | D 1.6 R | D 1.7 R | E 1.0 R | E 1.1 R | E 1.2 R | E 1.3 R |
|---|---|---|---|---|---|---|---|---|---|---|---|

ADDRESS 101      ADDRESS 280
(LOWER 4 BITS)

**FIG.19B**

MAIN DATA
(D0, 0F-D0,7F)

FIRST ERROR DETECTION CODE
(E0, 0F-E0, 7F)

| D0.0 | D0.1 | D0.2 | D0.3 | D0.4 | D0.5 | D0.6 | D0.7 | E0.0 | ... | | |
|------|------|------|------|------|------|------|------|------|-----|--|--|
| 0 | 1 | 0 | 0 | 0 | 1 | 1 | 0 | ... | | | |

...

| 0 | 0 | 1 | 1 | 0 | 1 | 0 | ... | | | | |
|---|---|---|---|---|---|---|-----|--|--|--|--|

P0.0    P0.1    P0.2    P0.3    P0.4    P0.5    P0.6    ...

PARITY CODE P

## FIG.20A

D0.0F    D0.1F    ...

D0.5F
(LEFT DATA)

D0.6F

D0.7F
(RIGHT DATA)

MAIN DATA D      0    1    0    ...    0    1    ⊠    0

PARITY CODE P      0    0    1    ...    0    1    0

P0.0    P0.1    ...

P0.5
(LEFT PARITY)

P0.6
(RIGHT PARITY)

## FIG.20B

EP 2 790 132 A2

FIG.21A

| BIT VALUE | BIT PAIR | |
|---|---|---|
| | R | F |
| 1 | → 0 | 1 |
| 0 | → 1 | 0 |

FIG.21B

EP 2 790 132 A2

EP 2 790 132 A2

D0.0  D0.1  D0.2  D0.3  D0.4  D0.5  D0.6  D0.7

F R F R F R F R F R F R F R F R

| 0 | 1 | 1 | 0 | 0 | 1 | 0 | 1 | 0 | 1 | 1 | 0 | 1 | 0 | 0 | 1 |

↓ DATA CORRUPTION          ↓ DATA CORRUPTION

| 0 | 1 | 1 | 0 | 0 | 0 | 0 | 1 | 0 | 1 | 0 | 0 | 1 | 0 | 0 | 1 |

$$\begin{pmatrix} 0 & 1 \\ 1 & 0 \end{pmatrix} \qquad \begin{pmatrix} 0 & 1 \\ 1 & 0 \end{pmatrix}$$

**FIG.22**

DATA WRITE PROCESS

START

A1 | DATA PREPARATION

A2 | DATA READING PROCESS

A3 | ECC DATA GENERATING PROCESS

A4 | LONGITUDINAL ECC DATA GENERATING PROCESS

A5 | PARITY DATA GENERATING PROCESS

A6 | PROCESS OF ENCODING TO BIT PAIR

A7 | DUPLEXING PROCESS

A8 | DATA WRITE

END

# FIG.23

DATA READING PROCESS

START

B1 | RELATED DATA READING PROCESS

B2 | ERROR DETECTION PROCESS

B3 < ERROR DETECTED? > NO

YES

B4 | ERROR CORRECTION PROCESS

B5 | CORRECTED DATA WRITING PROCESS

RETURN

**FIG.24**

START

D1 | READ 1

D2 | READ 2

D3 < R1=R2? > NO

YES

END

**FIG.25**

RELATED DATA READING PROCESS

FIG.26

ERROR CORRECTION PROCESS

START

E1 | PROCESS OF CORRECTING ERRORS IN FIRST
ERROR DETECTION CODE AND SUBSTITUTE DATA

E2 ERROR CORRECTION COMPLETED? YES

NO

E3 DATA DUPLICATED? NO

YES

E4 | PROCESS OF CORRECTING ERRORS
IN DUPLICATION

E5 ERROR CORRECTION COMPLETED? YES

NO

E6 PARITY CODE CONTAINED? NO

YES

E7 | PROCESS OF CORRECTING ERRORS
IN PARITY CODE

E8 ERROR CORRECTION COMPLETED? YES

NO

E9 SECOND ERROR CORRECTION
CODE CONTAINED? NO

YES

E10 | PROCESS OF CORRECTING ERRORS
IN SECOND ERROR DETECTION CODE

RETURN

# FIG.27

PROCESS OF CORRECTING ERRORS IN FIRST
ERROR DETECTION CODE AND SUBSTITUTE DATA

```
                    ┌──────────┐
                    │  START   │
                    └──────────┘
                         │
F1          ┌────────────────────────┐
            │          N=0           │
            └────────────────────────┘
                         │
F2
        YES ╱ NO ERROR OR 3 OR MORE ╲
       ┌────╲ BIT ERROR CONTAINED?  ╱
       │      ╲────────────────────╱
       │           │ NO
       │  F3  ┌────────────────────────┐
       │      │  PROCESS OF CORRECTING │
       │      │  DATA SUBSTITUTE ERROR │
       │      └────────────────────────┘
       │           │
       └──────────▶│
                   │
F4      ╱───────────────────╲  YES
        ╲      N<7?         ╱────┐
         ╲─────────────────╱     │
               │ NO              │
               │          F5 ┌──────────────┐
               │             │    N=N+1     │
               │             └──────────────┘
          ┌──────────┐
          │  RETURN  │
          └──────────┘
```

# FIG.28

PROCESS OF CORRECTING
ERRORS IN DUPLICATION

START

G1 | PROCESSING OF CORRECTING ECC ERRORS WITHIN BYTE ABOUT DUPLICATED DATA

G2
YES ◁ ERROR CORRECTION COMPLETED? ▷
NO

G3 | N=0

G4 | PROCESS OF CORRECTING LOGICAL ADDITION ERROR

G5
YES ◁ NO ERROR OR 3 OR MORE BIT ERROR CONTAINED? ▷
NO

G6 | PROCESS OF CORRECTING DATA SUBSTITUTE ERROR

G7 ◁ N<7? ▷ YES
NO

G8
N=N+1

RETURN

# FIG.29

PROCESS OF CORRECTING ERRORS
IN PARITY CODE

```
                    ┌──────────┐
                    │  START   │
                    └──────────┘
                         │
  H1  ┌──────────────────────────────────┐
      │              M=0                  │
      └──────────────────────────────────┘
                         │
  H2                     ▼
NO  ◁─────────  ERROR CONTAINED?  ──────────▷
                         │ YES
        ┌──────────────────────────┐  NO
  H5  ◁ │ NO ERROR IN LEFT DATA    │ ────────▷
        │ AND LEFT PARITY?         │
        └──────────────────────────┘
                         │ YES
  H6  ┌──────────────────────────────────┐
      │     DATA CORRECTION PROCESS       │
      └──────────────────────────────────┘

             ┌──────────────────────────┐  NO
  H7       ◁ │ NO ERROR IN RIGHT DATA    │ ──▷
             │ AND RIGHT PARITY?         │
             └──────────────────────────┘
                         │ YES
  H8  ┌──────────────────────────────────┐
      │     DATA CORRECTION PROCESS       │
      └──────────────────────────────────┘

  H3  ◁──────────  M<7?  ──────────▷ YES
                         │ NO            H4
                         │     ┌──────────────────┐
                         │     │     M=M+1         │
                         │     └──────────────────┘
                    ┌──────────┐
                    │  RETURN  │
                    └──────────┘
```

FIG.30

PROCESS OF CORRECTING ERRORS
IN SECOND ERROR DETECTION SIGNAL

```
                    ┌──────────┐
                    │  START   │
                    └──────────┘
                         │
    ┌────────────────────┤
    │              ┌──────────────────────┐
    │      I1      │        M=0           │
    │              └──────────────────────┘
    │                     │
    │      ┌──────────────┤◄──────────────────────────────┐
    │      │  I2                                           │
    │      │   NO LONGITUDINAL ERROR OR 3      YES         │
    │      │   OR MORE BIT ERROR CONTAINED?  ─────┐        │
    │      │         │NO                          │        │
    │      │  I3                                  │        │
    │      │  ┌──────────────────────┐            │        │
    │      │  PROCESS OF CORRECTING ERROR         │        │
    │      │  BY DATA SUBSTITUTION    │            │        │
    │      │  └──────────────────────┘            │        │
    │      │         │◄───────────────────────────┘        │
    │      │  I4                          YES              │
    │      │      M<11?              ─────────┐            │
    │      │         │NO                      │     I5     │
    │      │                         ┌──────────────────┐  │
    │      │                         │      M=M+1        │  │
    │      │  I6                     └──────────────────┘  │
    │      │  ┌──────────────────────┐                     │
    │      │  │        N=0           │─────────────────────┘
    │      │  └──────────────────────┘
    │      │         │
    │      │  ┌──────┤◄──────────────────────────────┐
    │      │  │  I7                                   │
    │      │  │   NO HORIZONTAL ERROR OR 3    YES     │
    │      │  │   OR MORE BIT ERROR CONTAINED? ──┐    │
    │      │  │         │NO                      │    │
    │      │  │  I8                              │    │
    │      │  │  ┌──────────────────────┐        │    │
    │      │  │  PROCESS OF CORRECTING ERROR     │    │
    │      │  │  BY DATA SUBSTITUTION   │        │    │
    │      │  │  └──────────────────────┘        │    │
    │      │  │         │◄───────────────────────┘    │
    │      │  │  I9                      YES          │
    │      │  │      N<7?           ─────────┐        │
    │      │  │         │NO                  │  I10   │
    │      │  │  I11                ┌──────────────┐  │
    │      │YES CORRECTION COMPLETED?│   N=N+1     │──┘
    │      └──                      └──────────────┘
    │                │NO
    │           ┌──────────┐
    │           │  RETURN  │
    │           └──────────┘
```

# FIG.31

EP 2 790 132 A2

ORIGINAL MAIN DATA

| D0.0 | D0.1 | D0.2 | D0.3 | D0.4 | D0.5 | D0.6 | D0.7 |
|------|------|------|------|------|------|------|------|

| F | R | F | R | F | R | F | R | F | R | F | R | F | R | F | R |
|---|---|---|---|---|---|---|---|---|---|---|---|---|---|---|---|
| 0 | 1 | 1 | 0 | 0 | 0 | 0 | 1 | 0 | 1 | 1 | 0 | 0 | 0 | 0 | 1 |

| 0 | 1 | 1 | 0 | 0 | 1 | 0 | 0 | 0 | 1 | 0 | 0 | 1 | 0 | 0 | 1 |
|---|---|---|---|---|---|---|---|---|---|---|---|---|---|---|---|
| F´ | R´ | F´ | R´ | F´ | R´ | F´ | R´ | F´ | R´ | F´ | R´ | F´ | R´ | F´ | R´ |

MULTIPLEXED DATA

BIT EXAMPLE OBTAINED BYLOGICAL OR OPERATION

| 0 | 1 | 1 | 0 | 0 | 1 | 0 | 1 | 0 | 1 | 1 | 0 | 1 | 0 | 0 | 1 |
|---|---|---|---|---|---|---|---|---|---|---|---|---|---|---|---|

# FIG.32

FIG.33

| D 0.0 F | D 0.0 R | D 0.1 F | D 0.1 R | D 0.2 F | D 0.2 R | D 0.3 F | D 0.3 R | D 0.4 F | D 0.4 R | D 0.5 F | D 0.5 R | D 0.6 F | D 0.6 R | D 0.7 F | D 0.7 R |
|---|---|---|---|---|---|---|---|---|---|---|---|---|---|---|---|

| E 0.0 F | E 0.0 R | E 0.1 F | E 0.1 R | E 0.2 F | E 0.2 R | E 0.3 F | E 0.3 R |
|---|---|---|---|---|---|---|---|

FIG.34

| E 0.0 F | E 0.0 R | E 0.1 F | E 0.1 R | E 0.2 F | E 0.2 R | E 0.3 F | E 0.3 R |
|---|---|---|---|---|---|---|---|

| D 0.0 F | D 0.0 R | D 0.1 F | D 0.1 R | D 0.2 F | D 0.2 R | D 0.3 F | D 0.3 R | D 0.4 F | D 0.4 R | D 0.5 F | D 0.5 R | D 0.6 F | D 0.6 R | D 0.7 F | D 0.7 R |
|---|---|---|---|---|---|---|---|---|---|---|---|---|---|---|---|

FIG. 35

PROCESS OF CORRECTING ERROR IN ID DATA

```
            ┌──────────────┐
            │    START     │
            └──────────────┘
                   │
 J1  ┌─────────────────────────────────┐
     │         OBTAINING ID DATA        │
     └─────────────────────────────────┘
                   │
 J2  ┌─────────────────────────────────┐
     │    READING ID DATA PAIR (USER)   │
     └─────────────────────────────────┘
                   │
 J3  ⟨  ERROR CONTAINED IN DATA PAIR?  ⟩── NO ──┐
                   │                            │
                  YES                           │
 J4  ┌─────────────────────────────────┐        │
     ║ PROCESSING OF CORRECTING ERROR IN ID DATA ║     │
     └─────────────────────────────────┘        │
                   │                            │
 J5  ┌─────────────────────────────────┐        │
     │    WITING ID DATA PAIR (USER)    │        │
     └─────────────────────────────────┘        │
                   │◄───────────────────────────┘
 J6  ┌─────────────────────────────────┐
     │   STARTING PROCESS USING ID NUMBER│
     └─────────────────────────────────┘
                   │
            ┌──────────────┐
            │     END      │
            └──────────────┘
```

# FIG.36

|  | MAIN | AUXILIARY | SIMPLIFIED |
|---|---|---|---|
| GENERAL PROGRAM AREA 102 (INCLDUING CONTROL PROGRAM) | ○ | | |
| MAIN ERROR CORRECTION PROGRAM AREA 103 | | ○ | ○ |
| AUXILIARY ERROR CORRECTION PROGRAM AREA 104 | ○ | | ○ |
| SIMPLIFIED ERROR CORRECTION PROGRAM AREA 105 | ○ | | |
| DATA AREA 101 | ○ | | |

PROGRAM AREA 100

FIG.37

START

K1 — INITIATING ERROR CORRECTION PROGRAM
(DESIGNATINGMAIN OR AUXILIARY)

K2 — OBTAINING ADRESS AREA AS OBJECT
TO BE CORRECTED

K3 — PROGRAM AREA? — NO

YES

K4 — SELF ERROR? — YES

NO

K5 — OBJECT PROGRAM? — NO

YES

K6 — STOPPING INITIATION OF PROGRAM

K7 — ERROR CORRECTION PROCESS

K8 — ERROR CONTAINED? — NO

YES

K9 — ERROR CORRECTION PROGRAM? — NO

YES

K10 — CORRECTABLE BY NORMAL
CORRECTION PROCESS? — YES

NO

K15 — ERROR CORRECTION PROCESS

K11 — SELF ERROR CORRECTION PROCESS

K12 — ERROR CONTAINED? — NO

YES

K13 — COPYING SELF PROGRAM
TO ERROR PORTION

K14 — INITIATING SIMPLIFIED CORRECTION
PROGRAM OF CORRECTION PROGRAM

FIG.38

START

L1 | DETECTING ERROR PORTION ADDRESS
OF MAIN ERRORCORRECTION PROGRAM

L2 | DETECTING AUXILIARY ERROR CORRECTION
PROGRAM PORTION AT THE ADDRESS

L3 < ERROR CONTAINED? > YES

NO

L4 | COPYING THE ADDRESS

L5 | DETECTING ERROR PORTION ADDRESS
OF AUXILIARY ERRORCORRECTION PROGRAM

L6 | DETECTING MAIN ERROR CORRECTION
PROGRAM AT THE ADDRESS

L7 < ERROR CONTAINED? > YES

NO

L8 | COPYING THE ADDRESS

END

# FIG.39

FIG. 40

210 202 220(223)

| D0,0 | D0,1 | D0,2 | D0,3 | D0,4 | D0,5 | D0,6 | D0,7 | E0,0 | E0,1 | E0,2 | E0,3 |
| D1,0 | D1,1 | D1,2 | D1,3 | D1,4 | D1,5 | D1,6 | D1,7 | E1,0 | E1,1 | E1,2 | E1,3 |
| D2,0 | D2,1 | D2,2 | D2,3 | D2,4 | D2,5 | D2,6 | D2,7 | E2,0 | E2,1 | E2,2 | E2,3 |
| D3,0 | D3,1 | D3,2 | D3,3 | D3,4 | D3,5 | D3,6 | D3,7 | E3,0 | E3,1 | E3,2 | E3,3 |
| D4,0 | D4,1 | D4,2 | D4,3 | D4,4 | D4,5 | D4,6 | D4,7 | E4,0 | E4,1 | E4,2 | E4,3 |
| D5,0 | D5,1 | D5,2 | D5,3 | D5,4 | D5,5 | D5,6 | D5,7 | E5,0 | E5,1 | E5,2 | E5,3 |
| D6,0 | D6,1 | D6,2 | D6,3 | D6,4 | D6,5 | D6,6 | D6,7 | E6,0 | E6,1 | E6,2 | E6,3 |
| D7,0 | D7,1 | D7,2 | D7,3 | D7,4 | D7,5 | D7,6 | D7,7 | E7,0 | E7,1 | E7,2 | E7,3 |

FIG. 41

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006098866 A
- JP 2006072804 A
- JP 10250426 A